# EUROPEAN PATENT APPLICATION

(11) **EP 4 539 641 A1**
(43) Date of publication of application: **16.04.2025**
(21) Application number: 23824209.3
(22) Date of filing: 13.06.2023
(51) Int. Cl.: H10K 50/11, H10K 50/15, H10K 50/16, H10K 85/60

(54) **PELLET FOR ORGANIC ELECTROLUMINESCENT DEVICE AND ORGANIC ELECTROLUMINESCENT DEVICE USING SAME**

(30) Priority: 13.06.2022 KR 20220071683
(71) Applicant: Solus Advanced Materials Co., Ltd., Iksan-si, Jeollabuk-do 54584 (KR)
(72) Inventor: KIM, Youngbae, Yongin-si, Gyeonggi-do 16858 (KR); PARK, Hocheol, Yongin-si, Gyeonggi-do 16858 (KR); JO, Hyunjong, Yongin-si, Gyeonggi-do 16858 (KR); JUNG, Hwasoon, Yongin-si, Gyeonggi-do 16858 (KR); SONG, Hyobum, Yongin-si, Gyeonggi-do 16858 (KR); KIM, Geunhyeong, Yongin-si, Gyeonggi-do 16858 (KR)
(74) Representative: Office Freylinger
(86) International application number: PCT/KR2023/008131
(87) International publication number: WO 2023/243995

(57) **Abstract**

The present invention relates to a pellet for an organic electroluminescent device and an organic electroluminescent device using same. The pellet for an organic electroluminescent device is prepared by compressing at least two kinds of organic compound powders containing a first organic compound powder and a second organic compound powder, wherein the pellet has the same maximum emission wavelength as the organic compound having the longer emission wavelength among the first and second organic compounds.

## Description

### Technical Field

The present invention relates to a pellet for an organic electroluminescent (EL) device and an organic electroluminescent device using same.

### Background Art

An organic electroluminescent device (hereinafter referred to as "organic EL device") operates by applying a voltage between two electrodes, wherein holes are injected from the anode and electrons are injected from the cathode into the organic layer. The injected holes and electrons combine with each other, forming excitons, and light is emitted as the excitons transition to the ground state. Based on the functions thereof, the organic materials used in the organic layer can be classified into light-emitting materials, hole-injection materials, hole-transport materials, electron-transport materials, electron-injection materials, and so on.

To improve the performance of such organic EL devices, particularly in terms of lifespan, efficiency, and driving voltage, the organic layer is made of multiple organic compounds, for example, at least one host material having a dopant dispersed therein. The organic layer is formed by evaporating each of the organic compounds individually. Controlling the deposition rate of each organic compound with precision was difficult, and it led to relative waste in terms of material utilization. Additionally, as organic compounds often take the form of powders and can become electrostatically charged, handling them during deposition posed challenges.

### Disclosure of Invention

### Technical Problem

The present invention aims to provide a pellet that not only exhibits excellent thermal and chemical stability but also has low surface resistance and a small specific surface area, enabling the implementation of a high-efficiency and long-lifespan organic electroluminescent (EL) device.

### Solution to Problem

To achieve the goal, the present invention provides a pellet for an organic EL device, which comprises two or more types of organic compound powders, including a first organic compound powder and a second organic compound powder that have been compressed, wherein the pellet has the same maximum emission wavelength as the organic compound with a longer emission wavelength among the first organic compound and the second organic compound.

The pellet of the present invention may have the same maximum emission wavelength as the mixture of the first organic compound powder and the second organic compound powder.

The pellet of the present invention may include a first region having a first organic compound powder compressed therein, and a second region having second organic compound powder compressed therein and integrated with the first region.

The pellet of the present invention may have the first and second regions alternately arranged in a radial direction from the center outward.

The pellet of the present invention may have the first and second regions arranged in a longitudinal direction. In this regard, the first and second regions may be arranged in an alternating pattern.

The pellet of the present invention may have the first and second regions alternately arranged in a circumferential direction. In this regard, the first and second regions may be alternately arranged in an upper and lower configuration.

The pellet of the present invention may have a shape selected from the group consisting of polyhedral, cylindrical, and spherical shapes.

In the pellet of the present invention, the first and second organic compound powders may be included at a weight ratio of 1:99 to 99:1.

In the pellet of the present invention, both the first and second organic compound powders may be sublimable powders.

In the pellet of the present invention, the first and second organic compound powders may have a deposition temperature difference of 0 to 30°C under a pressure of 10⁻⁶ torr.

In the pellet of the present invention, the first organic compound may be a hole-transporting organic compound, and the second organic compound may be an electron-transporting organic compound. In this regard, the hole-transporting organic compound may be a hole-transporting host, which may be a carbazole-based compound. The electron-transporting organic compound may be an electron-transporting host, which may be an azine-based compound.

The pellet of the present invention may be a molded body formed by injection molding under a pressure of 20,000 to 40,000 kgf/cm² to the two or more organic compound powders, without heat treatment.

The pellet of the present invention may have a BET specific surface area smaller than that of the simple mixture of the first and second organic compound powders.

The pellet of the present invention may have a surface resistance smaller than that of the simple mixture of the first and second organic compound powders.

The present invention provides an organic electroluminescent device including: an anode; a cathode; and at least one organic layer interposed between the anode and cathode, wherein at least one of the organic layers is a homogeneous thin film containing the first and second organic compounds formed using the pellet.

### Advantageous Effects of Invention

The pellet according to the present invention not only exhibits excellent thermal and chemical stability but also has low surface resistance, a small specific surface area, and superior reproducibility and uniformity of the thin film, thereby enabling the implementation of a high-efficiency and long-lifespan organic EL device.

### Brief Description of Drawings

FIG. 1 shows schematic perspective views of shapes of the pellets according to the present invention.
FIG. 2 is a schematic cross-sectional view of an organic electroluminescent device according to the first embodiment of the present invention.
FIG. 3 is a schematic cross-sectional view of an organic electroluminescent device according to the second embodiment of the present invention.
FIG. 4 is a schematic cross-sectional view of an organic electroluminescent device according to the third embodiment of the present invention.

### <Description of Reference Numerals>

10: Pellet, 11: First region
12: Second region, 13: Third region
100: Anode, 200: Cathode
300: Organic layer, 310: Hole injection layer
320: Hole transport layer, 330: Emission layer
340: Electron transport layer, 350: Electron injection layer
360: Electron transport auxiliary layer

### Best Mode for Carrying out the Invention

Hereinafter, Hereinafter, a detailed description will be given of the present invention.

All terms (including technical and scientific terms) used in this specification may be interpreted as having the meaning commonly understood by those skilled in the art to which the present invention pertains, unless otherwise defined. Additionally, terms defined in generally used dictionaries should not be interpreted ideally or overly, unless explicitly defined otherwise.

Throughout the specification, when a certain part "includes" a certain component, it is understood that this is an open-ended term that allows the inclusion of other components, unless explicitly stated otherwise.

Also, throughout the specification, terms such as "on" or "above" should be interpreted to include not only cases where a part is directly above or below a target part, but also cases where there is another part in between, and it does not necessarily imply a direction based on gravity.

Furthermore, in this specification, terms such as "first" and "second" are used to distinguish components from each other, not to indicate any particular order or importance.

### <Pellet for Organic Electroluminescent Device>

The present invention provides a pellet for forming an organic layer (e.g., an emission layer) of an organic electroluminescent (EL) device.

The pellet according to the present invention is a molded body wherein two or more types of organic compound powders including a first organic compound powder and a second organic compound powder are compressed, and the pellet has a maximum emission wavelength equal to that of the organic compound with the longer emission wavelength between the first and second organic compounds.

Specifically, in the pellet of the present invention, the first organic compound powder and the second organic compound powder are simply mixed and compressed without heat treatment and thus densified without undergoing any chemical changes. Thus, the pellet of the present invention is manufactured without any chemical changes in the first and second organic compound powders. Therefore, the maximum emission wavelength of the pellet is the same as the maximum emission wavelength of the organic compound with the longer emission wavelength among the first and second organic compounds, and it is also same as the maximum emission wavelength of the simple mixture of the first and second organic compound powders. Furthermore, the pellet of the present invention has a BET specific surface area smaller than that of the simple mixture of the first and second organic compound powders. As a result, the pellet of the present invention has a small surface area exposed to air, providing superior chemical resistance and thermal stability. Additionally, because being lower in surface resistance than the simple mixture of the first and second organic compound powders, the pellet according to the present invention generates less static electricity and is easier to handle. Hence, the pellet can improve the processability of deposition during the fabrication of the device. The pellet of the present invention is not only easy to store and handle but can also be designed in various shapes as desired. Moreover, the pellet of the present invention can be used as a single evaporation source, allowing for easy control of the deposition rate, which simplifies the deposition process and reduces manufacturing costs. Furthermore, when forming an organic layer of an organic EL device using the pellet of the present invention, a homogeneous thin film can be formed, where the first and second organic compounds are uniformly mixed, as opposed to using the first and second organic compound powders separately or in a simple mixed state. Thus, the pellet enables the implementation of a high-efficiency and long-lifespan organic EL device. Additionally, the pellet of the present invention exhibits excellent reproducibility of thin films during continuous processes such as roll-to-roll manufacturing, allowing the continuous production of organic EL devices.

In the pellet of the present invention, both the first and second organic compound powders are solid at room temperature and sublimable. As a result, the pellet of the present invention can easily be formed into a homogeneous thin film using dry film-forming methods such as vacuum deposition.

For example, the first and second organic compound powders may have a sublimation temperature difference of approximately 0 to 30°C under a pressure of 10⁻⁶ torr. Thus, the first and second organic compound powders may have a deposition temperature difference of approximately 0 to 30°C under a pressure of 10⁻⁶ torr. In this context, the pellet of the present invention can be deposited while maintaining the set mixing ratio.

The first organic compound usable in the present invention is not particularly limited, as long as it is a hole-transporting organic compound with stronger hole-transporting properties than the second organic compound.

The hole-transporting organic compound may be a hole-transporting host. For example, the hole-transporting host may be a carbazole-based compound.

Specifically, examples of the hole-transporting organic compound include, but are not limited to, compounds represented by Chemical Formula 1: 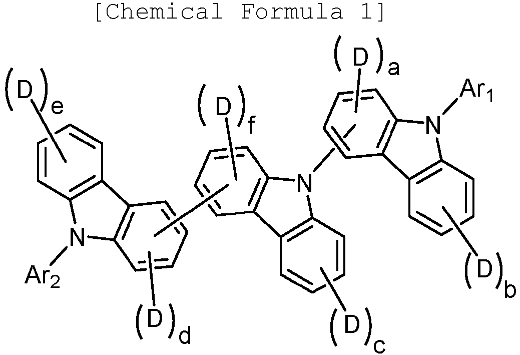 wherein,
D represents a deuterium atom,
a, d, and f are each an integer of 0 to 3,
b, c, and e are each an integer of 0 to 4,
Ar₁ and Ar₂, which are same or different, may each be independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group having 3 to 40 nuclear atoms, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group,
the alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, arylamine group and fused ring of Ar₁ and Ar₂ may not or may each independently have one or more substituents selected from the group consisting of a deuterium atom, a halogen group, a cyano group, a nitro group, an alkenyl group of C₂-C₄₀, an alkynyl group of C₂-C₄₀, a cycloalkyl group of C₃-C₄₀ a heterocycloalkyl group having 3 to 40 nuclear atoms, an alkyl group of C₁-C₄₀, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀, with a proviso that when there are two or more substituents, they may be same or different.

In the compound represented by Chemical Formula 1, a, d, and f are each an integer of 0 to 3, b, c, and e are each an integer of 0 to 4. Herein, given that a, b, c, d, e, and f are each 0, it is meant that none of the hydrogen atoms on the compound are substituted with deuterium (D). Given that a, d, and f are each an integer of 1 to 3 and b, c, and e are each an integer of 1 to 4, it is meant that one or more hydrogen atoms on the compound are substituted with deuterium (D). In this regard, there may be 13≤a+b+c+d+e+f≤21. According to an embodiment, the number of deuterium atoms (D) contained in the compound of Chemical Formula 1 may be at least 13, or specifically at least 21. This compound of Chemical Formula 1 can enhance the stability of the chemical structure through deuterium (D) substitution, enabling the simultaneous realization of characteristics such as low voltage, high efficiency, and long lifespan of the organic electroluminescent device.

The deuterium may also be substituted with another substituent (R). When there are multiple substituents (R), they may be same or different. The other substituent (R) may be selected from the group consisting of a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group having 3 to 40 nuclear atoms, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkylphosphine oxide group of C₁-C₄₀, an arylphosphine group of C₆-C₆₀, an arylphosphine oxide group of C₆-C₆₀, and an arylamine group of C₆-C₆₀.

In the compound represented by Chemical Formula 1, Ar₁ and Ar₂, which are same or different, may each be independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group having 3 to 40 nuclear atoms, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group. Specifically, Ar₁ and Ar₂ are same or different and may each be independently selected from the group consisting of an aryl group of C₆-C₆₀ and a heteroaryl group having 5 to 60 nuclear atoms.

In an embodiment, Ar₁ and Ar₂ are same or different and may each be a substituent independently selected from the group consisting of the following substituents S1 to S4: 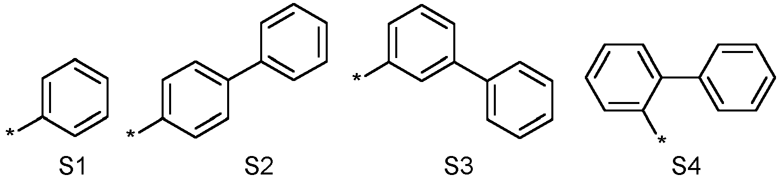 wherein, * represents a bonding site to Chemical Formula 1.

Depending on Ar₁ and Ar₂, the compound of Chemical Formula 1 may be a compound represented by Chemical Formula 2, but with no limitations thereto: 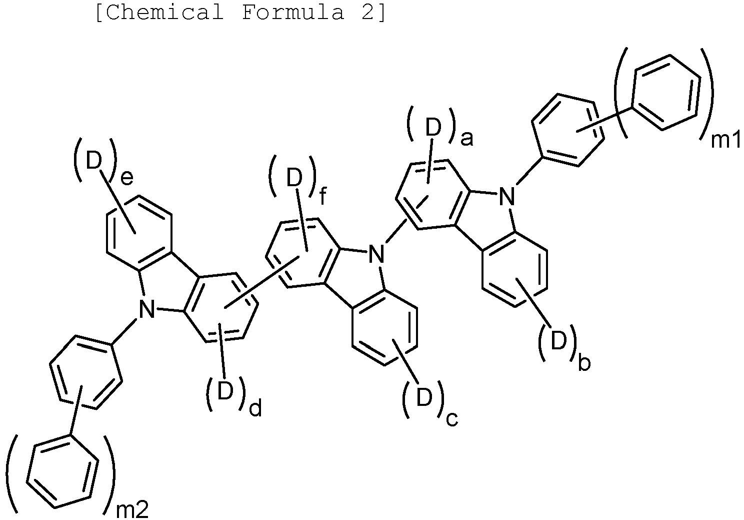 wherein,
a, b, c, d, e, and f are each as defined in Chemical Formula 1,
m1 and m2 are each 0 or 1.

In addition, the compound represented by Chemical Formula 1 may have various structures depending on the linkage positions between the carbazole moieties. In an embodiment, the compound of Chemical Formula 1 may be the compound represented by the following Chemical Formula 3: 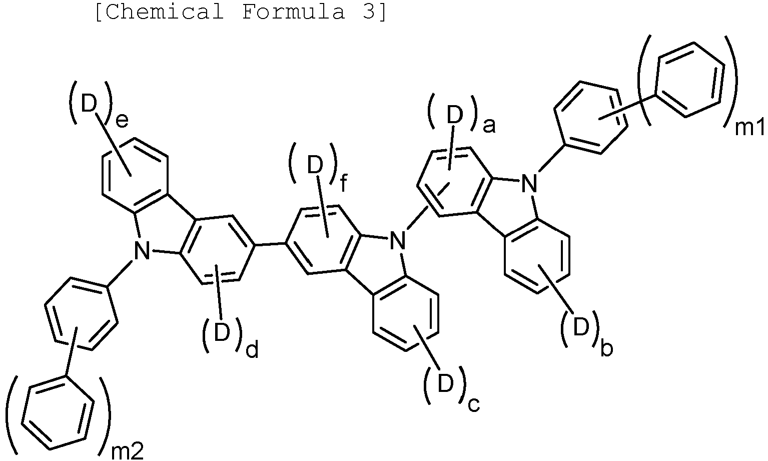 wherein,
a, b, c, d, e, and f are each as defined in Chemical Formula 1, and
m1 and m2 are each 0 or 1.

The compound represented by Chemical Formula 1 according to the present invention may be further specified as the following exemplary compounds, for example, compounds A-1 to D-4, but is not limited thereto:

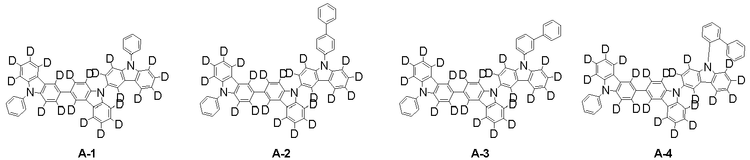

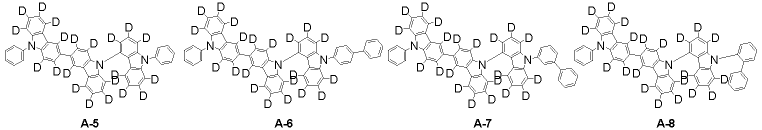

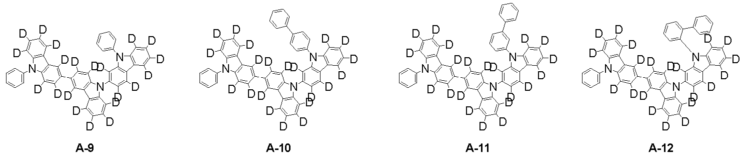

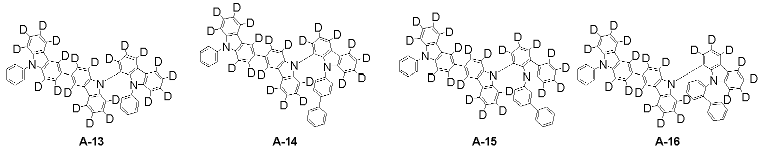

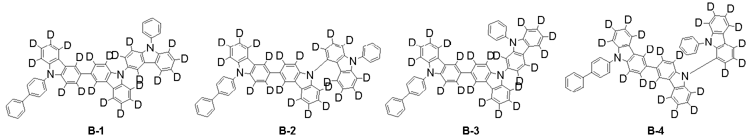

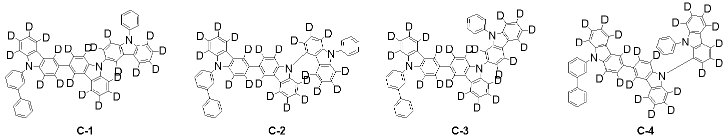

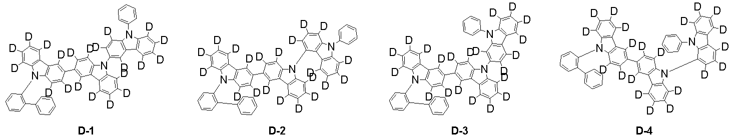

The second organic compound available in the present invention is not particularly limited as long as it is an electron-transporting organic compound with stronger electron-transporting properties than the first organic compound.

The electron-transporting organic compound may be an electron-transporting host. In an embodiment, the electron-transporting host may be an azine-based compound including a triazine group, a pyridine group, a pyrimidine group, or the like.

Specifically, the electron-transporting organic compound may be a compound represented by Chemical Formula 4, but is not limited thereto: 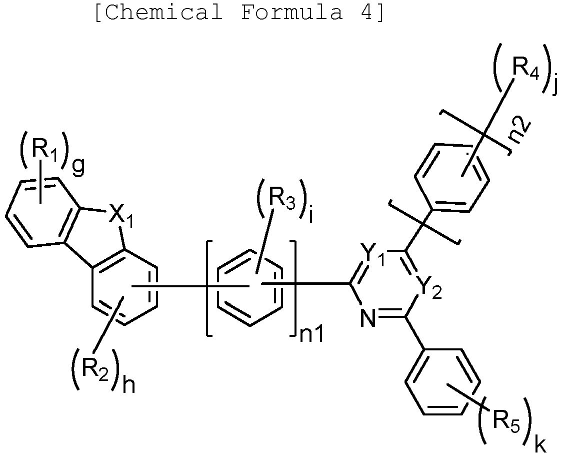 wherein,
h is an integer of 0 to 3,
g and i are each an integer of 0 to 4,
j and k are each an integer of 0 to 5,
n1 is an integer of 1 to 5,
n2 is an integer of 0 or 1,
X₁ is selected from the group consisting of O, S, Se, N(Ar₃), C(Ar₄)(Ar₅), and Si(Ar₆)(Ar₇),
Y₁ and Y₂, which are same or different, are each independently N or C(Ar₈), with a proviso that at least one of Y₁ and Y₂ is N,
Ar₃ to Ar₈ and R₁ to R₅, which are same or different, are each independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group having 3 to 40 nuclear atoms, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group, and
the alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, arylamine group and fused ring of Ar₃ to Ar₈ and R₁ to R₅ may not or may each independently have one or more substituents selected from the group consisting of a deuterium atom, a halogen group, a cyano group, a nitro group, an alkenyl group of C₂-C₄₀, an alkynyl group of C₂-C₄₀, a cycloalkyl group of C₃-C₄₀, a heterocycloalkyl group having 3 to 40 nuclear atoms, an alkyl group of C₁-C₄₀, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀, with a proviso that when there are two or more substituents, they may be same or different.

In the compound represented by Chemical Formula 4, Y₁ and Y₂, which are same or different, are each independently N or C(Ar₈), with a proviso that at least one of Y₁ and Y₂ is N.

Depending on Y₁ and Y₂, the moiety 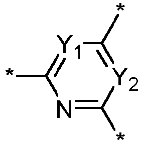 in the compound represented by Chemical Formula 4 may be selected from the group consisting of the following moieties Mo-1 to Mo-3: 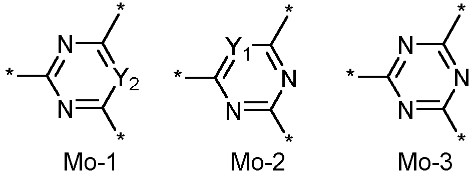 wherein,
* is a bonding site to Chemical Formula 4,
Y₁ and Y₂ are each independently C(Ar₈), and
Ar₈ is as defined in Chemical Formula 4.

In the compound represented by Chemical Formula 4, n1 is an integer of 1 to 5, and n2 is 0 or 1. In an embodiment, n1 may be 1 or 2 and n2 may be 0 or 1. In Chemical Formula 4, when n2 is 0, j is 1.

In the compound represented by Chemical Formula 4, X₁ is selected from the group consisting of O, S, Se, N(Ar₃), C(Ar₄)(Ar₅), and Si(Ar₆)(Ar₇). Depending on X₁, the dibenzo moiety may be a monovalent dibenzofuran group, a monovalent dibenzothiphene group, a monovalent fluorene group, etc.

Ar₃ to Ar₈, which are same or different, may each be independently selected from the group consisting of a hydrogen atom, a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group having 3 to 40 nuclear atoms, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group (e.g., Ar₃-R₁, Ar₃-R₂, Ar₄-Ar₅, Ar₆-Ar₇, Ar₄-R₁, Ar₄-R₂, Ar₆-R₁, Ar₆-R₂, etc.). Specifically, Ar₃ to Ar₈, which are same or different, may each be independently selected from the group consisting of an alkyl group of C₁-C₄₀, an aryl group of C₆-C₆₀ and a heteroaryl group having 5 to 60 nuclear atoms and may form a fused ring with an adjacent group (e.g., Ar₃-R₁, Ar₃-R₂, Ar₄-Ar₅, Ar₆-Ar₇, Ar₄-R₁, Ar₄-R₂, Ar₆-R₁, Ar₆-R₂, etc.). Here, the fused ring may be at least one selected from the group consisting of a fused aliphatic ring of C₃-C₆₀ (specifically, a fused aliphatic ring of C₃-C₃₀), a fused aromatic ring of C₆-C₆₀ (specifically, a fused aromatic ring of C₆-C₃₀), a 5- to 60-membered fused heteroaromatic ring (specifically, 5-to 30-membered fused heteroaromatic ring), a spiro ring of C₃-C₆₀, and a combination thereof.

According to an embodiment, the moiety 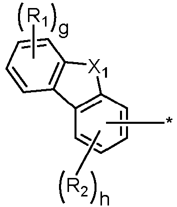 in Chemical Formula 4 may be selected from the group consisting of the following moieties Dz-1 to Dz-32, but with no limitations thereto: 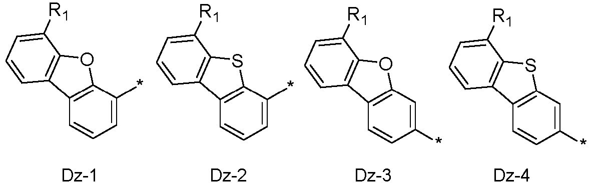 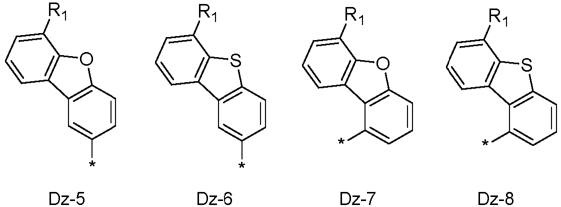 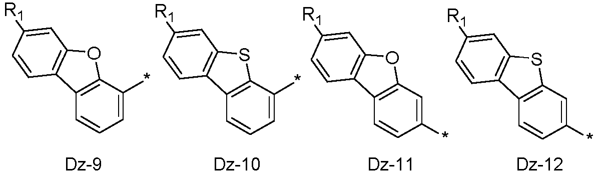 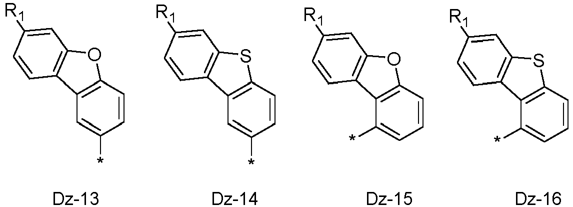 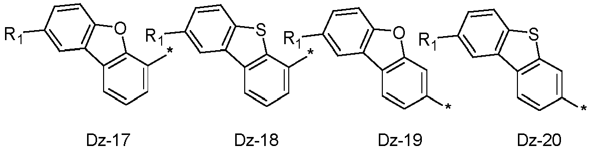 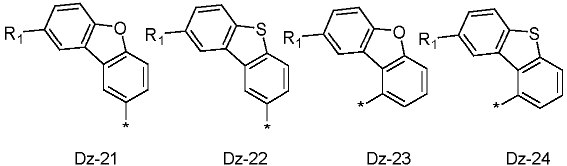 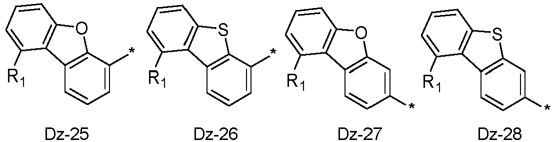 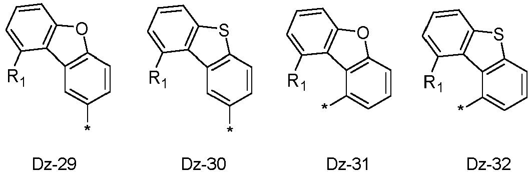 wherein,
* is a bonding site to Chemical Formula 4, and
R₁ may be an aryl group of C₆-C₆₀, and specifically a phenyl.

In the compound represented by Chemical Formula 4, h is an integer of 0 to 3, g and i are each an integer of 0 to 4, and j and k are each an integer of 0 to 5. Here, given that g, h, i, j, and k are each 0, it is meant that none of the hydrogen atoms on the compound are substituted with deuterium (D). When h is an integer of 1 to 3, g and i are each an integer of 1 to 4, and j and k are each an integer of 1 to 5, one or more R₁ to R₅, which are same or different, may each independently selected from the group consisting of a deuterium atom (D), a halogen group, a cyano group, a nitro group, an amino group, an alkyl group of C₁-C₄₀, an alkenyl group of C₂-C₄₀, an alkynyl group of C₂-C₄₀, a cycloalkyl group of C₃-C₄₀, a heterocycloalkyl group having 3 to 40 nuclear atoms, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, a phosphine oxide group, an alkylphosphine oxide group of C₁-C₄₀, an arylphosphine group of C₆-C₆₀, an arylphosphine oxide group of C₆-C₆₀, and an arylamine group of C₆-C₆₀, or may form a fused ring with an adjacent group. Specifically, one or more R₁ to R₅, which are same or different, may each be independently selected from the group consisting of a hydrogen atom, a halogen group, a cyano group, a nitro group, an amino group, an alkyl group of C₁-C₄₀, an aryl group of C₆-C₆₀, and a heteroaryl group having 5 to 60 nuclear atoms.

The alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, and arylamine group and the fused ring of Ar₃ to Ar₈ and R₁ to R₅ may not or may each independently have at least one substituent selected from the group consisting of a deuterium atom, a halogen group, a cyano group, a nitro group, an alkenyl group of C₂-C₄₀, an alkynyl group of C₂-C₄₀, a cycloalkyl group of C₃-C₄₀, a heterocycloalkyl group having 3 to 40 nuclear atoms, an alkyl group of C₁-C₄₀, an aryl group of C₆-C₆₀, a heteroaryl group having 5 to 60 nuclear atoms, an alkyloxy group of C₁-C₄₀, an aryloxy group of C₆-C₆₀, an alkylsilyl group of C₁-C₄₀, an arylsilyl group of C₆-C₆₀, an alkylboron group of C₁-C₄₀, an arylboron group of C₆-C₆₀, an arylphosphine group of C₆-C₆₀, an arylphosphine oxide group of C₆-C₆₀, and an arylamine group of C₆-C₆₀. When there are two or more substituents, they are same or different.

The compound of Chemical Formula 4 may be a compound represented by the following Chemical Formula 5, but is not limited thereto: 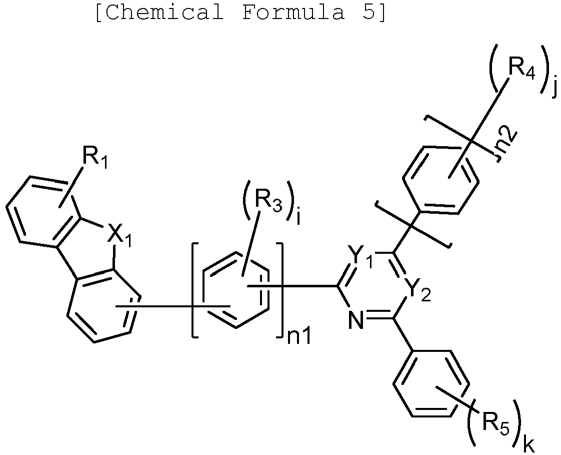 wherein,
i, j, k, R₁, R₃ to R₅, n1, n2, X₁, Y₁, and Y₂ are each as defined in Chemical Formula 4.

Specifically, the compound of Chemical Formula 4 may be a compound represented by the following Chemical Formula 6 or 7, but with no limitations thereto: 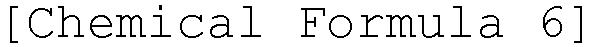 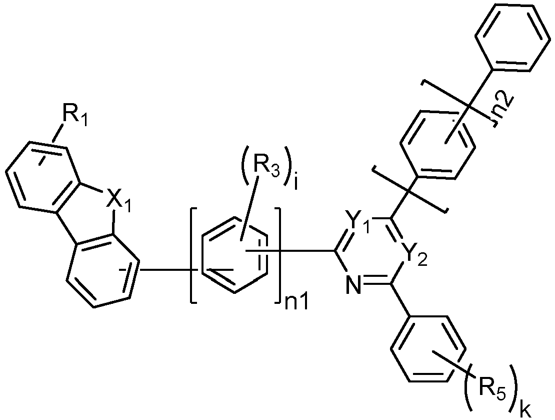 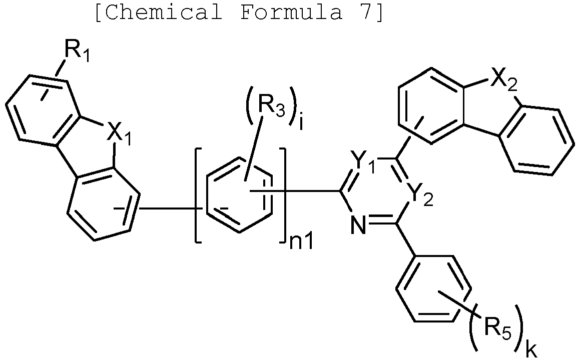 wherein,
i, k, R₁, R₃, R₅, n1, n2, Y₁, and Y₂ are each as defined in Chemical Formula 4,
X₁ and X₂ may each be O or S and specifically O.

More specifically, the compound of Chemical Formula 4 may be a compound represented by the following Chemical Formula 8 or 9, but is not limited thereto: 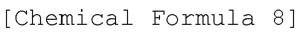 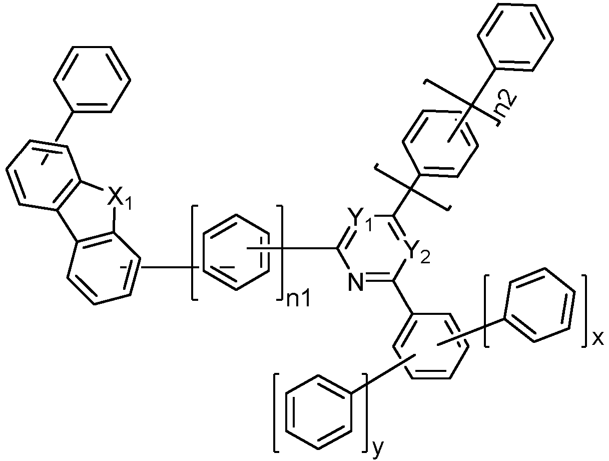 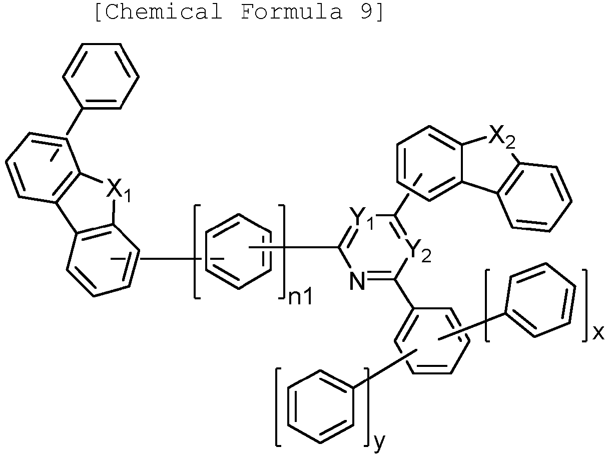 wherein,
n1, n2, Y₁, and Y₂ are each as defined in Chemical Formula 4, and specifically n1 is 1 or 2, n2 is 0 or 1, and Y₁ and Y₂ are both N,
x and y may each be 0 or 1,
X₁ and X₂ may each be O or S and specifically may be O.

The compound represented by Chemical Formula 2 according to the present invention may be further specified as the following exemplary compounds, for example, compounds E-1 to E-10, but is not limited thereto:

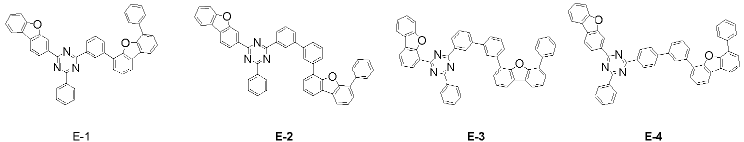

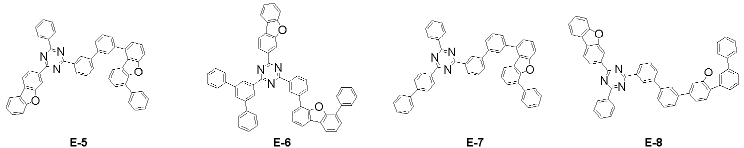

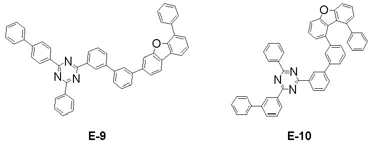

As used herein, the term "alkyl" refers to a monovalent substituent derived from a linear or branched saturated hydrocarbon having 1 to 40 carbon atoms. Examples include methyl, ethyl, propyl, isobutyl, sec-butyl, pentyl, isoamyl, hexyl, and the like, but are not limited thereto.

As used herein, the term "alkenyl" refers to a monovalent substituent derived from a linear or branched unsaturated hydrocarbon of 2 to 40 carbon atoms and containing at least one carbon-carbon double bond. Examples include vinyl, allyl, isopropenyl, 2-butenyl, and the like, but are not limited thereto.

As used herein, the term, "alkynyl" refers to a monovalent substituent derived from a linear or branched unsaturated hydrocarbon of 2 to 40 carbon atoms and containing at least one carbon-carbon triple bond. Examples include ethynyl, 2-propynyl, and the like, but are not limited thereto.

As used herein, the term "cycloalkyl" refers to a monovalent substituent derived from a monocyclic or polycyclic non-aromatic hydrocarbon of 3 to 40 carbon atoms. Examples of cycloalkyl include cyclopropyl, cyclopentyl, cyclohexyl, norbornyl, adamantyl, and the like, but are not limited thereto.

As used herein, the term "heterocycloalkyl" refers to a monovalent substituent derived from a non-aromatic hydrocarbon of 3 to 40 nuclear atoms, in which one or more carbon atoms, preferably 1 to 3 carbon atoms, in the ring are replaced by heteroatoms such as N, O, S, or Se. Examples of heterocycloalkyl include morpholinyl and piperazinyl, but are not limited thereto.

As used herein, the term "aryl" refers to a monovalent substituent derived from an aromatic hydrocarbon of 6 to 60 carbon atoms, either as a single ring or as a combination of two or more rings. The combination may include pendant rings or fused rings. Examples of aryl include phenyl, naphthyl, phenanthryl, and anthryl, but are not limited thereto.

As used herein, the term "heteroaryl" refers to a monovalent substituent derived from a monocyclic or polycyclic aromatic hydrocarbon of 5 to 60 ring atoms, where one or more carbon atoms, preferably 1 to 3 carbon atoms, in the ring are replaced by heteroatoms such as N, O, S, or Se. It may include simple pendant or fused rings and may also include fused forms with aryl groups. Examples of such heteroaryl include pyridyl, pyrazinyl, pyrimidinyl, pyridazinyl, triazinyl (six-membered monocyclic rings), phenoxathienyl, indolizinyl, indolyl, purinyl, quinolyl, benzothiazolyl, carbazolyl (polycyclic rings), 2-furanyl, N-imidazolyl, 2-isoxazolyl, 2-pyridyl, and 2-pyrimidinyl, but are not limited thereto.

As used herein, the term "alkoxy" refers to a monovalent substituent represented by R'O-, where R' refers to an alkyl group of 1 to 40 carbon atoms, which may have a linear, branched, or cyclic structure. Examples of alkoxy include methoxy, ethoxy, n-propoxy, 1-propoxy, t-butoxy, n-butoxy, and pentoxy, but are not limited thereto.

As used herein, the term "aryloxy" refers to a monovalent substituent represented by RO-, where R refers to an aryl group of 5 to 40 carbon atoms. Examples of such aryloxy include phenoxy, naphthoxy, diphenoxy, and the like, but are not limited thereto.

As used herein, the term "alkylsilyl" refers to a silyl substituted with an alkyl group of 1 to 40 carbon atoms, and includes mono-, di-, and trialkylsilyl groups. In addition, "arylsilyl" refers to a silyl substituted with an aryl group of 5 to 60 carbon atoms, and includes mono-, di-, and triarylsilyl, as well as polyarylsilyl.

As used herein, the term "alkylboron" refers to a boron group substituted with an alkyl group of 1 to 40 carbon atoms, and "arylboron" refers to a boron substituted with an aryl group of 6 to 60 carbon atoms.

As used herein, the term "alkylphosphinyl" refers to a phosphine substituted with an alkyl group of 1 to 40 carbon atoms, and includes mono- as well as dialkylphosphinyl. Likewise, "arylphosphinyl" refers to a phosphine substituted with a monoaryl or diaryl group of 6 to 60 carbon atoms, and includes mono- as well as diarylphosphinyl groups.

As used herein, the term "aryl amine" refers to an amine substituted with an aryl group of 6 to 60 carbon atoms, and includes mono- as well as diaryl amines.

As used herein, the term "heteroaryl amine" refers to an amine substituted with a heteroaryl group having 5 to 60 nuclear atoms, and includes mono- as well as di-heteroaryl amines.

As used herein, "(aryl) (heteroaryl)amine" refers to an amine substituted with an aryl group of 6 to 60 carbon atoms and a heteroaryl group having 5 to 60 ring atoms.

As used herein, the term "fused ring" refers to a fused aliphatic ring of 3 to 40 carbon atoms, a fused aromatic ring of 6 to 60 carbon atoms, a fused heteroaliphatic ring of 3 to 60 ring atoms, a fused heteroaromatic ring of 5 to 60 ring atoms, a spiro ring of 3 to 60 carbon atoms, or a combination thereof.

No particular limitations are imparted to the mixing ratio of the first organic compound powder and the second organic compound powder. For example, the first and the second organic compound powder may be used at a weight ratio of 1:99 to 99:1. In an embodiment, the pellet may contain the first organic compound powder and the second organic compound powder at a weight ratio of 20:80 to 80:20. This ensures that a uniform mixing ratio is maintained during deposition, allowing stable control of the homogeneous mixing ratio characteristics

The particle size and shape of the first organic compound powder and the second organic compound powder are not particularly limited, as long as they are known in the art, and for example, the powders may be white or pale yellow.

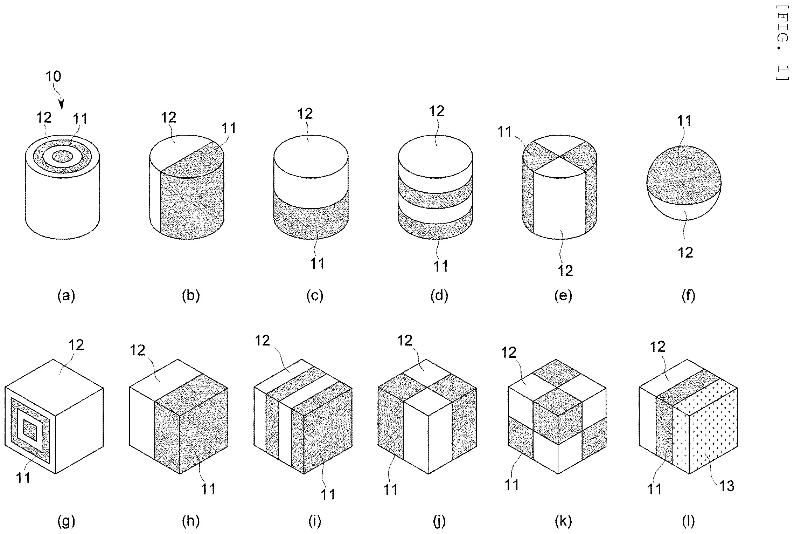

In the pellet of the present invention, the first and second organic compound powders may be uniformly mixed together as a compressed state or may be arranged in predetermined regions with a specific pattern as a compressed state. In this way, when the pellet is divided into a first region containing the first organic compound and a second region containing the second organic compound in a predetermined pattern, the mixing ratio of the first and second organic compounds can be kept constant at the set ratio during continuous processes (e.g., roll-to-roll processes) for thin film deposition, compared to when the first organic compound and the second organic compound are mixed together, thereby improving the reproducibility of the thin film formation. Particularly, when the pellet of the present invention is structured such that one organic compound with higher sublimability is encapsulated by another organic compound (see FIGS. 1(a) and (g)), the thin film can be formed with a stable set mixing ratio during deposition, compared to other structures.

Specifically, as shown in FIG. 1, the pellet (10) of the present invention may include a first region (11) where the first organic compound powder is compressed and a second region (12) disposed to integrate with the first region (11), where the second organic compound powder is compressed. Here, the first and second regions (11, 12) may be arranged in various patterns.

In an embodiment, as shown in FIGS. 1(a) and (g), the first region (11) and the second region (12) of the pellet (10) may be alternately arranged radially from the center outward.

In another embodiment, as shown in FIGS. 1(c), (d), (h), (i), (j), and (f), the first region (11) and the second region (12) of the pellet (10) may be arranged in the longitudinal direction (e.g., vertically). Here, the first and second regions (11, 12) may be alternately arranged [see FIGS. 1(d) and (i)].

In another embodiment, as shown in FIGS. 1(e), (j), and (k), the first region (11) and the second region (12) of the pellet (10) may be alternately arranged in the circumferential direction. In this regard, the first region (11) and the second region (12) may be alternately arranged vertically.

In yet another example, as shown in FIG. 1(l), the pellet (10) may include, in addition to the first region (11) and the second region (12), a third region (13) where a third organic compound powder, different from the first and second organic compounds, is compressed,.., n^{th} region (not shown) where n^{th} organic compound powders (4 ≤ n, specifically 4 ≤ n ≤ 6) are compressed.

The shape of the pellet is not particularly limited and may be, for example, polyhedral, cylindrical, or spherical.

As described above, the pellet of the present invention, which has a specific shape, may have a BET specific surface area smaller than that of a simple mixture of the first and second organic compound powders.

Additionally, the surface resistance of the pellet of the present invention may be smaller than that of a simple mixture of the first and second organic compound powders.

Moreover, unlike the simple mixture of the first and second organic compounds, the pellet of the present invention maintains a consistent mixing ratio of the first and second organic compounds before and after deposition, even when forming thin films through continuous processes. Therefore, the pellet of the present invention allows the formation of thin films with a uniform mixing ratio during deposition in continuous processes. In an embodiment, the temporal variation rate before and after deposition of the pellet of the present invention during continuous thin-film deposition may be about 1% or less, specifically about 0.01% to 0.8%.

The pellet of the present invention can be manufactured by conventional pellet molding methods known in the industry. However, since the pellet of the present invention is not heat-treated during compression, it undergoes no chemical changes and thus maintains the same chemical and physical properties as the first and second organic compound powders and their simple mixtures.

According to an embodiment, the pellet of the present invention may be manufactured by injecting two or more types of organic compound powders, including the first and second organic compound powders, into a mold and applying a pressure of about 20,000 to 40,000 kgf/cm² to same without heat treatment, followed by injection molding.

### <Organic Electroluminescent Device>

The present invention also provides an organic electroluminescent device (hereinafter referred to as "organic EL device") using the aforementioned pellet.

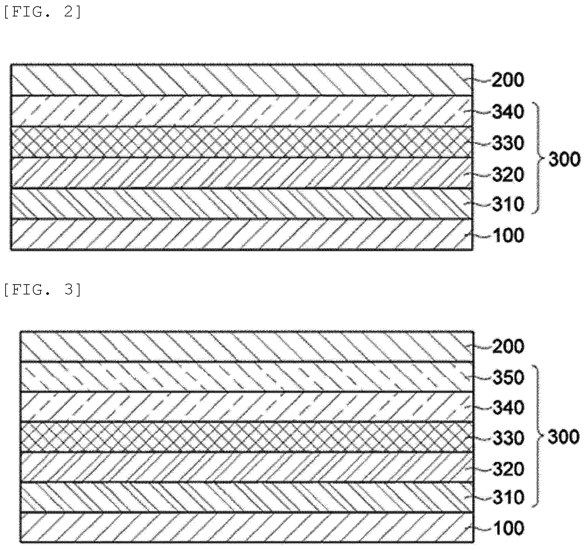

Specifically, as shown in FIGS. 2 to 4, the organic EL device according to the present invention includes an anode (100), a cathode (200), and at least one organic layer (300) interposed between the anode and the cathode, where at least one of the organic layers is formed from the pellet and is a homogeneous thin film containing the first organic compound and the second organic compound.

The at least one organic layer (300) may include one or more of a hole injection layer (310), a hole transport layer (320), an emission layer (330), an electron transport auxiliary layer (360), an electron transport layer (340), and an electron injection layer (350). Among them, at least one organic layer (300) is formed from the pellet, creating a homogeneous thin film containing the first and second organic compounds. In this regard, the first organic compound may be a hole-transporting organic compound, and the second organic compound may be an electron-transporting organic compound.

In an embodiment, the homogeneous thin film may be the emission layer (330). In this regard, the first organic compound may be a hole-transporting host, and the second organic compound may be an electron-transporting host.

The first organic compound and the second organic compound may be mixed at a weight ratio of 1:99 to 99:1, specifically 20:80 to 80:20.

The emission layer may further include hosts and/or dopants commonly known in the art in addition to the first and second organic compounds. Here, the total content of the first and second organic compounds may be 0% to 100% by weight, based on the total weight of the host.

Moreover, the total weight of the host may be about 70% to 99.9% by weight, based on the total weight of the emission layer, and the dopant content may be about 0.1% to 30% by weight, based on the total weight of the emission layer.

The structure of the organic EL device of the present invention is not particularly limited, but, for example, an anode (100), at least one organic layer (300), and a cathode (200) may be sequentially stacked on a substrate (see FIGS. 2 to 4). In addition, although not shown, the structure may include an insulating layer or an adhesive layer inserted between the electrodes and the organic layer.

In an embodiment, as shown in FIG. 2, the organic EL device may have a structure in which an anode (100), a hole injection layer (310), a hole transport layer (320), an emission layer (330), an electron transport layer

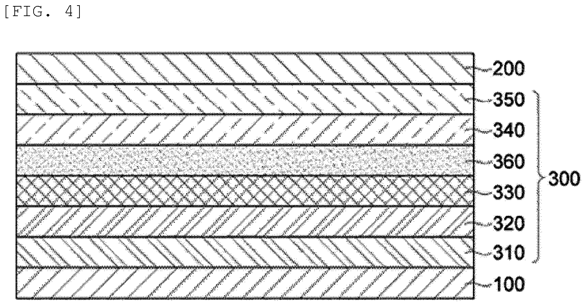

(340), and a cathode (200) are sequentially stacked on a substrate. Alternatively, as shown in FIG. 3, an electron injection layer (350) may be positioned between the electron transport layer (340) and the cathode (200). Furthermore, an electron transport auxiliary layer (360) may be positioned between the emission layer (330) and the electron transport layer (340) (see FIG. 4).

The organic EL device of the present invention can be manufactured by forming the organic layers and electrodes using materials and methods known in the art, except that at least one organic layer (300) (e.g., the emission layer (330)) is a homogeneous thin film formed from the aforementioned pellet.

The organic layers may be formed by dry film formation methods such as vacuum deposition, sputtering, plasma deposition, or ion plating.

The substrate usable in the present invention is not particularly limited, and non-limiting examples include silicon wafers, quartz, glass plates, metal plates, plastic films, and sheets.

Examples of anode materials include metals such as vanadium, chromium, copper, zinc, and gold, or alloys thereof; metal oxides such as zinc oxide, indium oxide, indium tin oxide (ITO), and indium zinc oxide (IZO); combinations of metals and oxides such as ZnO:Al or SnO₂:Sb; conductive polymers such as polythiophene, poly(3-methylthiophene), poly[3,4-(ethylene-1,2-dioxy)thiophene] (PEDT), polypyrrole, or polyaniline; and carbon black, but are not limited thereto.

Examples of cathode materials include metals such as magnesium, calcium, sodium, potassium, titanium, indium, yttrium, lithium, gadolinium, aluminum, silver (Ag), tin, or lead, or alloys thereof; and multilayer structures such as LiF/Al or LiO₂/Al, but are not limited thereto.

Moreover, the hole injection layer, hole transport layer, emission layer, and electron injection layer are not particularly limited, and conventional materials known in the art may be used.

A better understanding of the present invention may be obtained via the following examples, which are set forth to illustrate, but are not to be construed to limit, the present invention.

### <PREPARATION EXAMPLE 1-1> Synthesis of Cz-D1

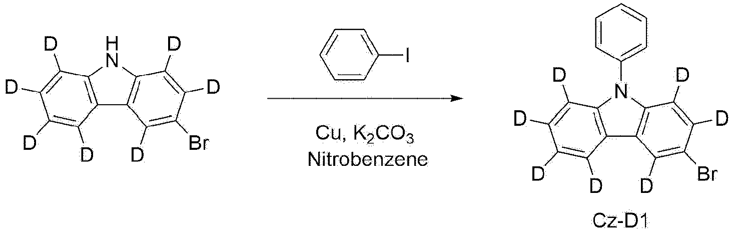

Under a nitrogen atmosphere, 3-bromo-9H-carbazole-1,2,4,5,6,7,8-d7 (134.3 g, 530.6 mmol), iodobenzene (130.0 g, 636.7 mmol), Cu (16.8 g, 265.3 mmol), K₂CO₃ (146.7 g, 1,061.3 mmol), and toluene (1000 ml) were mixed and stirred at 110°C for 12 hours.

After completion of the reaction, the reaction mixture was subjected to extraction with ethyl acetate and the extract was dried over MgSO₄. Purification by column chromatography (hexane : EA = 5:1 (v/v)) afforded Cz-D1 (125.7 g, yield 72%).

Mass (Calcd.: 329.25, Found: 329 g/mol)

### <PREPARATION EXAMPLE 1-2> Synthesis of Cz-D2

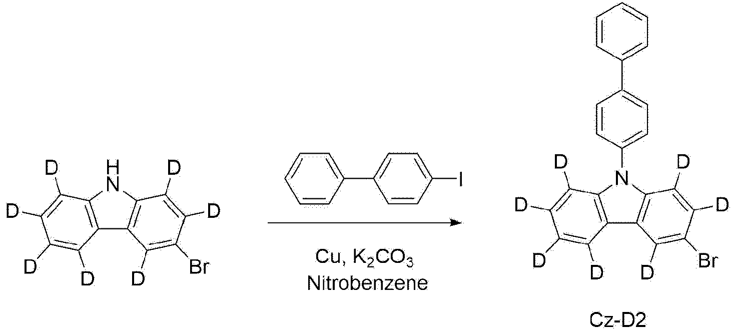

The same procedure as in Preparation Example 1-1, with the exception of using 4-iodo-1,1'-biphenyl (178.3 g, 636.7 mmol) instead of iodobenzene, was conducted to afford the target compound Cz-D2 (135.5 g, yield 63%).

Mass (Calcd.: 405.35, Found: 405 g/mol)

### <PREPARATION EXAMPLE 1-3> Synthesis of Cz-D3

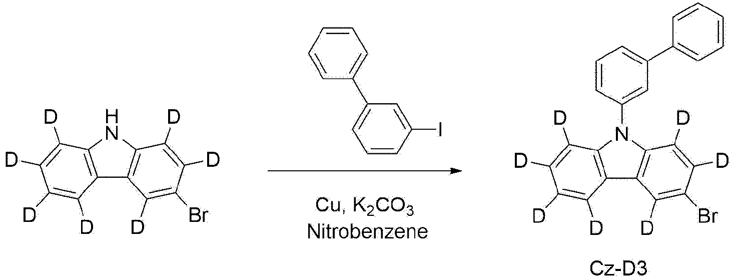

The same procedure as in Preparation Example 1-1, with the exception of using 3-iodo-1,1'-biphenyl (178.3 g, 636.7 mmol) instead of iodobenzene, was conducted to afford the target compound Cz-D3 (148.4 g, yield 69%).

Mass (Calcd.: 405.35, Found: 405 g/mol)

### <PREPARATION EXAMPLE 1-4> Synthesis of Cz-D4

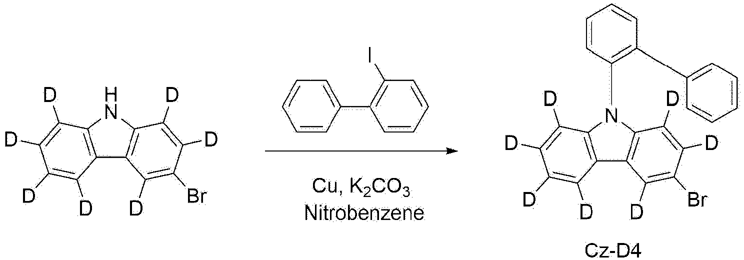

The same procedure as in Preparation Example 1-1, with the exception of using 2-iodo-1,1'-biphenyl (178.3 g, 636.7 mmol) instead of iodobenzene, was conducted to afford the target compound Cz-D4 (96.8 g, yield 45%).

Mass (Calcd.: 405.35, Found: 405 g/mol)

### <PREPARATION EXAMPLE 2-1> Synthesis of Cz-D5

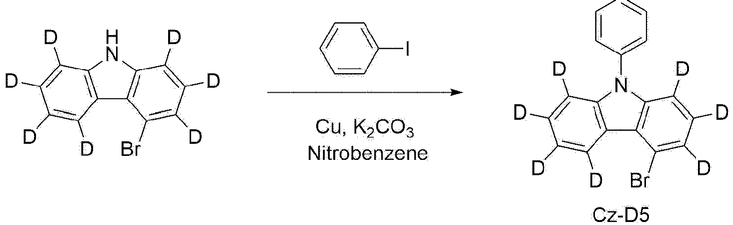

The same procedure as in Preparation Example 1-1, with the exception of using 4-bromo-9H-carbazole-1,2,3,5,6,7,8-d7 (134.3 g, 530.6 mmol) instead of 3-bromo-9H-carbazole-1,2,4,5,6,7,8-d7, was conducted to afford the target compound Cz-D5 (117.1 g, yield 67%).

Mass (Calcd.: 329.25, Found: 329 g/mol)

### <PREPARATION EXAMPLE 2-2> Synthesis of Cz-D6

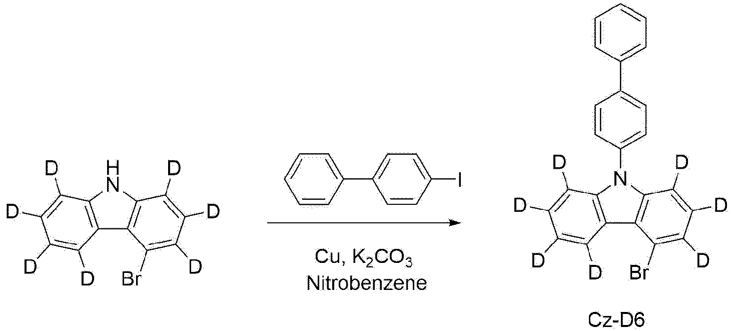

The same procedure as in Preparation Example 2-1, with the exception of using 4-iodo-1,1'-biphenyl (178.3 g, 636.7 mmol) instead of iodobenzene, was conducted to afford the target compound Cz-D6 (139.8 g, yield 65%).

Mass (Calcd.: 405.35, Found: 405 g/mol)

### <PREPARATION EXAMPLE 2-3> Synthesis of Cz-D7

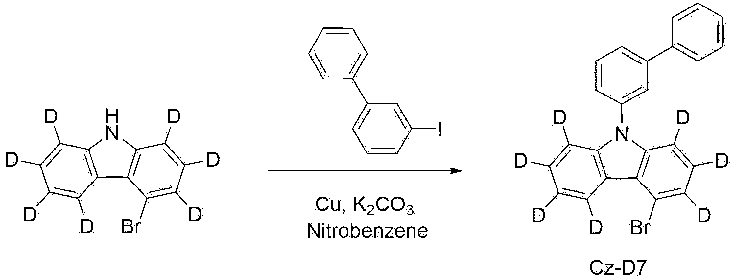

The same procedure as in Preparation Example 2-1, with the exception of using 3-iodo-1,1'-biphenyl (178.3 g, 636.7 mmol) instead of iodobenzene, was conducted to afford the target compound Cz-D7 (152.7 g, yield 71%).

Mass (Calcd.: 405.35, Found: 405 g/mol)

### <PREPARATION EXAMPLE 2-4> Synthesis of Cz-D8

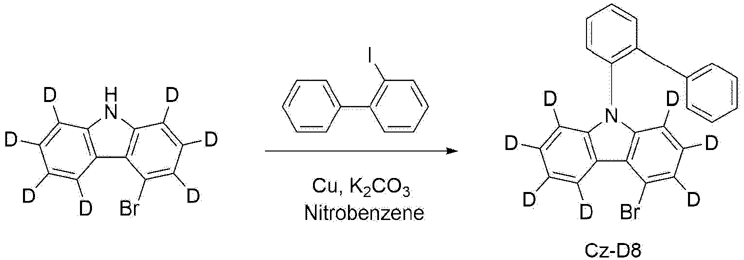

The same procedure as in Preparation Example 2-1, with the exception of using 2-iodo-1,1'-biphenyl (178.3 g, 636.7 mmol) instead of iodobenzene, was conducted to afford the target compound Cz-D8 (75.2 g, yield 35%).

Mass (Calcd.: 405.35, Found: 405 g/mol)

### <PREPARATION EXAMPLE 3-1> Synthesis of Cz-D9

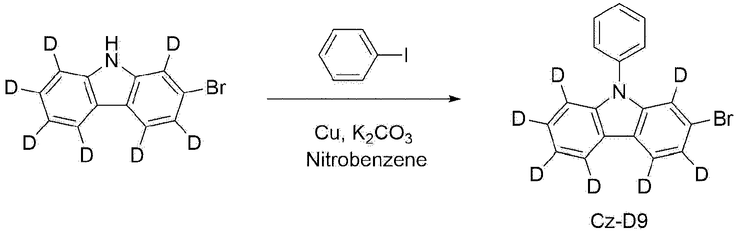

The same procedure as in Preparation Example 1-1, with the exception of using 2-bromo-9H-carbazole-1,3,4,5,6,7,8-d7 (134.3 g, 530.6 mmol) instead of 3-bromo-9H-carbazole-1,2,4,5,6,7,8-d7, was conducted to afford the target compound Cz-D9 (134.5 g, yield 77%).

Mass (Calcd.: 329.25, Found: 329 g/mol)

### <PREPARATION EXAMPLE 3-2> Synthesis of Cz-D10

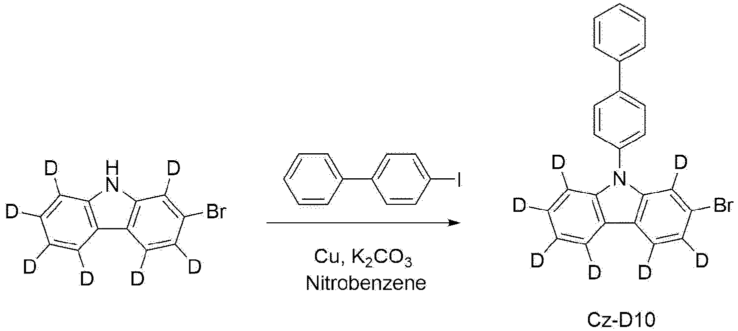

The same procedure as in Preparation Example 3-1, with the exception of using 4-iodo-1,1'-biphenyl (178.3 g, 636.7 mmol) instead of iodobenzene, was conducted to afford the target compound Cz-D10 (159.1 g, yield 74%).

Mass (Calcd.: 405.35, Found: 405 g/mol)

### <PREPARATION EXAMPLE 3-3> Synthesis of Cz-D11

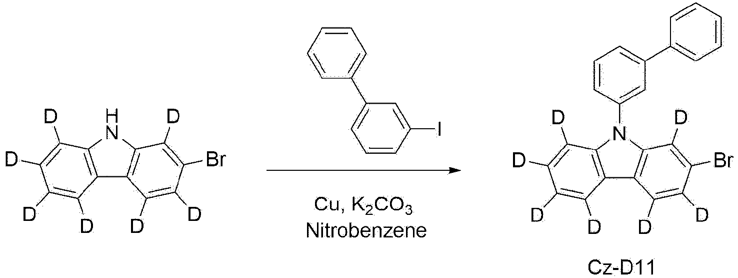

The same procedure as in Preparation Example 3-1, with the exception of using 3-iodo-1,1'-biphenyl (178.3 g, 636.7 mmol) instead of iodobenzene, was conducted to afford the target compound Cz-D11 (163.4 g, yield 76%).

Mass (Calcd.: 405.35, Found: 405 g/mol)

### <PREPARATION EXAMPLE 3-4> Synthesis of Cz-D12

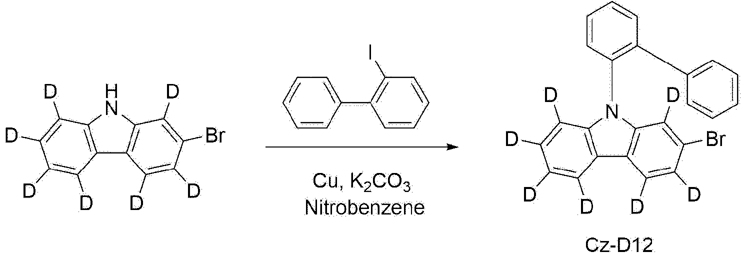

The same procedure as in Preparation Example 3-1, with the exception of using 2-iodo-1,1'-biphenyl (178.3 g, 636.7 mmol) instead of Iodobenzene, was conducted to afford the target compound Cz-D12 (92.4 g, yield 43%).

Mass (Calcd.: 405.35, Found: 405 g/mol)

### <PREPARATION EXAMPLE 4-1> Synthesis of Cz-D13

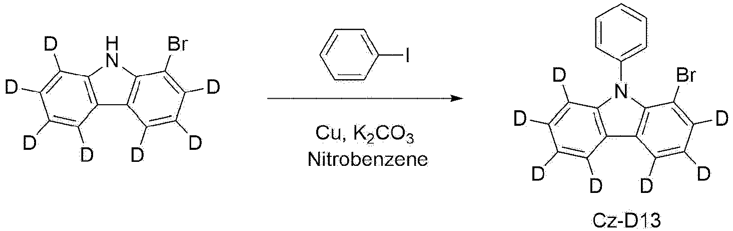

The same procedure as in Preparation Example 1-1, with the exception of using 1-bromo-9H-carbazole-2,3,4,5,6,7,8-d7 (134.3 g, 530.6 mmol) instead of 3-bromo-9H-carbazole-1,2,4,5,6,7,8-d7, was conducted to afford the target compound Cz-D13 (94.3 g, yield 54%).

Mass (Calcd.: 329.25, Found: 329 g/mol)

### <PREPARATION EXAMPLE 4-2> Synthesis of Cz-D14

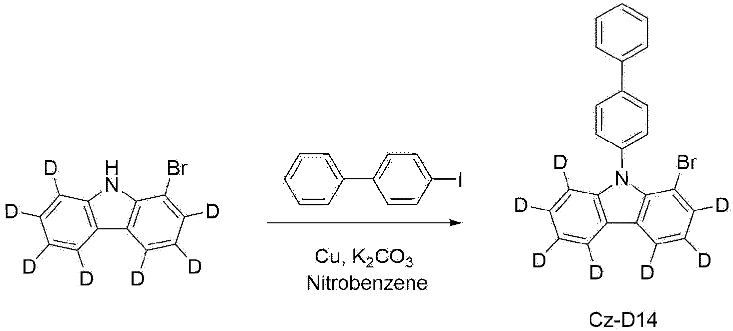

The same procedure as in Preparation Example 4-1, with the exception of using 4-iodo-1,1'-biphenyl (178.3 g, 636.7 mmol) instead of iodobenzene, was conducted to afford the target compound Cz-D14 (122.6 g, yield 57%).

Mass (Calcd.: 405.35, Found: 405 g/mol)

### <PREPARATION EXAMPLE 4-3> Synthesis of Cz-D15

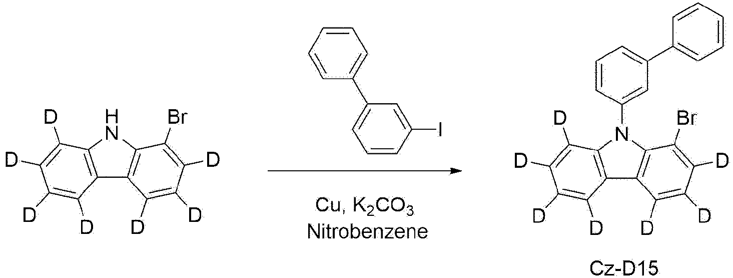

The same procedure as in Preparation Example 4-1, with the exception of using 3-iodo-1,1'-biphenyl (178.3 g, 636.7 mmol) instead of iodobenzene, was conducted to afford the target compound Cz-D15 (111.8 g, yield 52%).

Mass (Calcd.: 405.35, Found: 405 g/mol)

### <PREPARATION EXAMPLE 4-4> Synthesis of Cz-D16

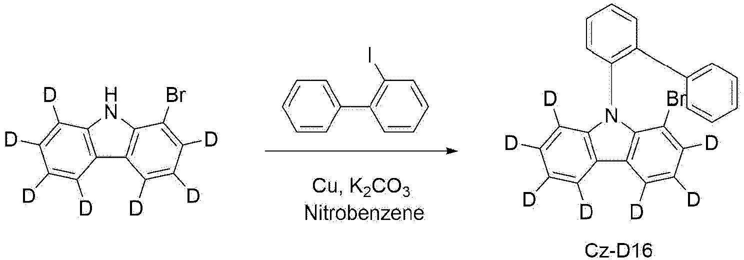

The same procedure as in Preparation Example 4-1, with the exception of using 2-iodo-1,1'-biphenyl (178.3 g, 636.7 mmol) instead of iodobenzene, was conducted to afford the target compound Cz-D16 (68.8 g, yield 32%).

Mass (Calcd.: 405.35, Found: 405 g/mol)

### <PREPARATION EXAMPLE 5-1> Synthesis of BCz-D1

### <Step 1> Synthesis of 9-phenyl-3-(4,4,5,5-tetramethyl-1,3,2-dioxaborolan-2-yl)-9H-carbazole-1,2,4,5,6,7,8-d7

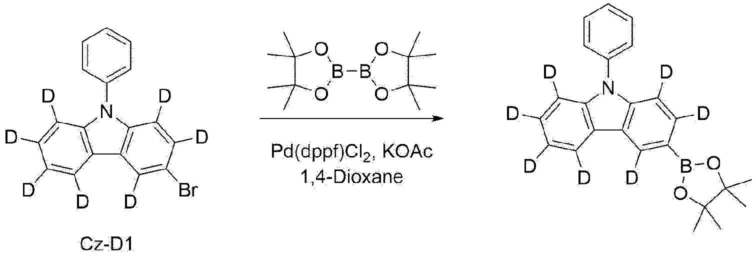

Under a nitrogen atmosphere, Cz-D1 (100.0 g, 303.7 mmol), 4,4,4',4',5,5, 5',5'-octamethyl-2,2'-bi(1,3,2-dioxaborolane) (84.8 g, 334.1 mmol), Pd(dppf)Cl₂ (26.6 g, 30.3 mmol), KOAc (85.8 g, 911.1 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane:EA = 8:1 (v/v)) afforded 9-phenyl-3-(4,4,5,5-tetramethyl-1,3,2-dioxaborolan-2-yl)-9H-carbazole-1,2,4,5,6,7,8-d7 (96.0 g, yield 84%).

Mass (Calcd.: 376.3, Found: 376 g/mol)

### <Step 2> Synthesis of BCz-D1

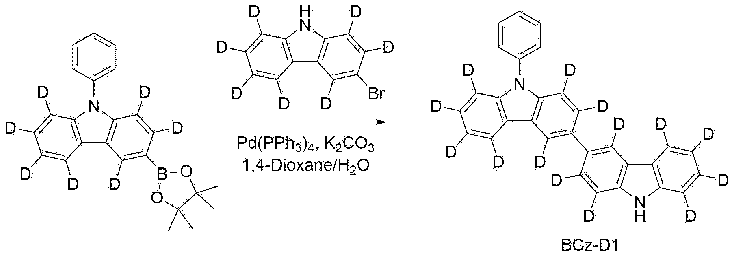

Under a nitrogen atmosphere, 9-phenyl-3-(4,4,5,5-tetramethyl-1,3,2-dioxaborolan-2-yl)-9H-carbazole-1,2,4,5,6,7,8-d7 (96.0 g, 255.1 mmol), 3-bromo-9H-carbazole-1,2,4,5,6,7,8-d7 (77.5 g, 306.1 mmol), Pd(PPh₃)₄ (14.7 g, 12.7 mmol), K₂CO₃ (88.1 g, 637.8 mmol), 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:EA = 7:1 (v/v)) to afford BCz-D1 (71.1 g, yield 66%).

Mass (Calcd.: 422.59, Found: 422 g/mol)

### <PREPARATION EXAMPLE 5-2> Synthesis of BCz-D2

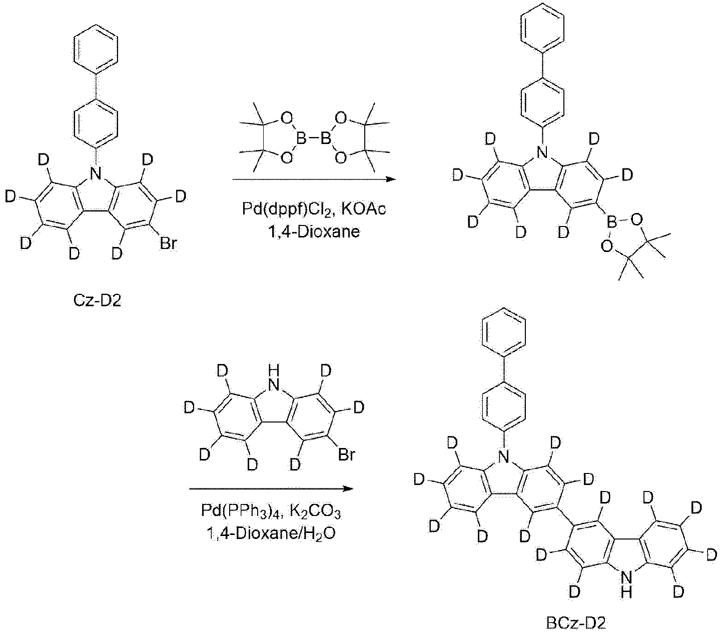

The same procedure as in Preparation Example 5-1, with the exception of using Cz-D2(100g, 246.7 mmol) instead of Cz-D1, was conducted to afford the target compound BCz-D2 (66.4 g, final yield 54.0%).

Mass (Calcd.: 498.69, Found: 498 g/mol)

### <PREPARATION EXAMPLE 5-3> Synthesis of BCz-D3

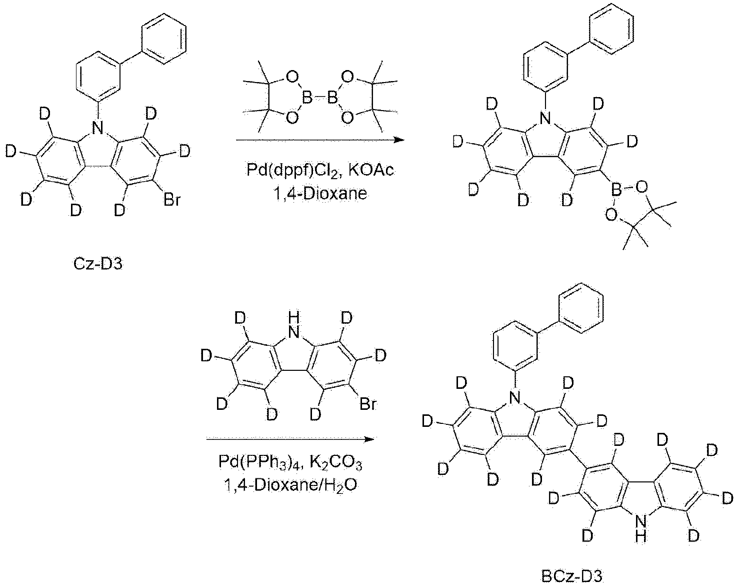

The same procedure as in Preparation Example 5-1, with the exception of using Cz-D3(100g, 246.7 mmol) instead of Cz-D1, was conducted to afford the target compound BCz-D3 (59.7 g, final yield 48.5%).

Mass (Calcd.: 498.69, Found: 498 g/mol)

### <PREPARATION EXAMPLE 5-4> Synthesis of BCz-D4

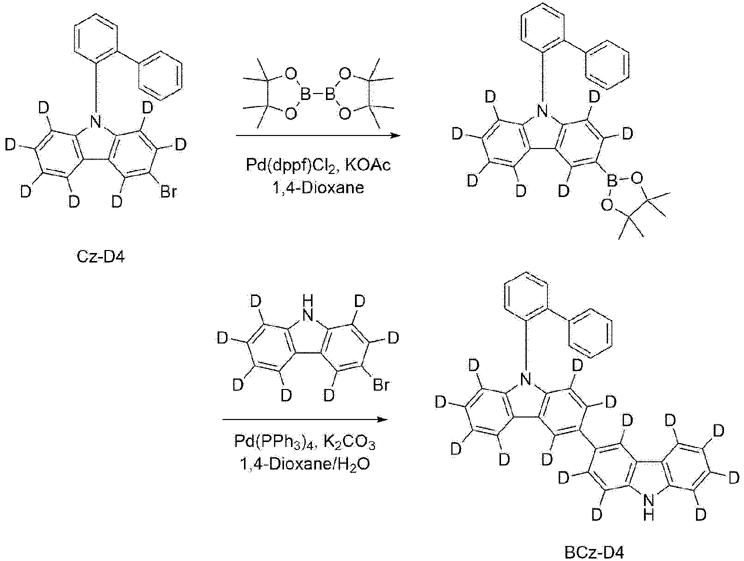

The same procedure as in Preparation Example 5-1, with the exception of using Cz-D4 (100g, 246.7 mmol) obtained in Preparation Example 1-4 instead of Cz-D1, was conducted to afford the target compound BCz-D4 (59.4 g, final yield 48.3%).

Mass (Calcd.: 498.69, Found: 498 g/mol)

### [SYNTHESIS EXAMPLE 1] Synthesis of A-1

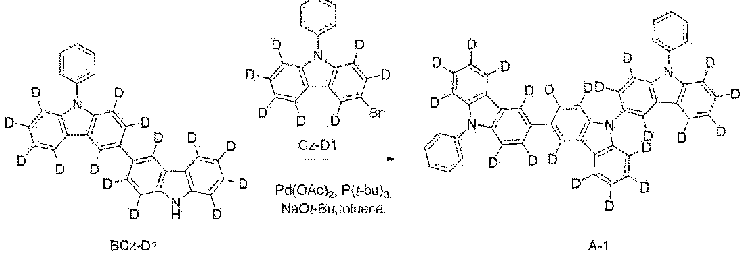

Under a nitrogen atmosphere, BCz-D1 (10.0 g, 23.6 mmol) obtained Preparation Example 5-1, Cz-D1 (9.3 g, 28.3 mmol) obtained Preparation Example 1-1, Pd(OAc)₂ (1.36 g, 1.18 mmol), P(*t*-Bu)₃ (0.57 ml, 2.36 mmol), NaO(*t*-Bu) (4.55 g, 47.3 mmol), and toluene (100 ml) were mixed and stirred at 110°C for 5 hours. After completion of the reaction, the toluene was concentrated and the solid salt was filtered, followed by filtration through recrystallization to afford the target compound A-1 (13.0 g, yield 82%).

Mass (Calcd.: 670.93, Found: 670 g/mol)

### [SYNTHESIS EXAMPLE 2] Synthesis of A-2

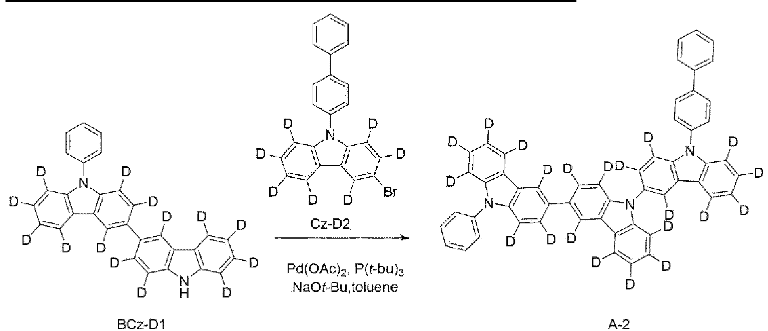

The same procedure as in Synthesis Example 1, with the exception of using Cz-D2 (10.0 g, 23.6 mmol) prepared in Preparation Example 1-2 instead of Cz-D1, was conducted to afford the target compound A-2 (13.8 g, yield 78%).

Mass (Calcd.: 747.02, Found: 747 g/mol)

### [SYNTHESIS EXAMPLE 3] Synthesis of A-3

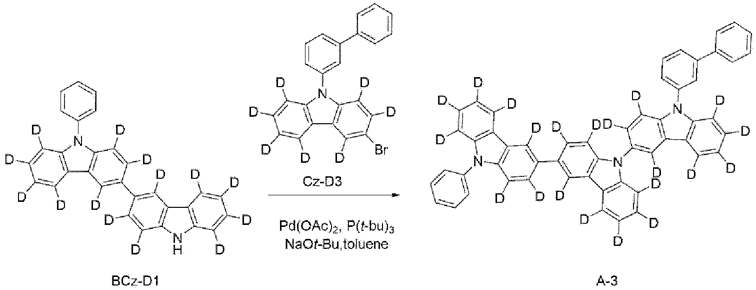

The same procedure as in Synthesis Example 1, with the exception of using Cz-D3 (10.0 g, 23.6 mmol) obtained in Preparation Example 1-3 instead of Cz-D1, was conducted to afford the target compound A-3 (13.2 g, yield 75%).

Mass (Calcd.: 747.02, Found: 747 g/mol)

### [SYNTHESIS EXAMPLE 4] Synthesis of A-4

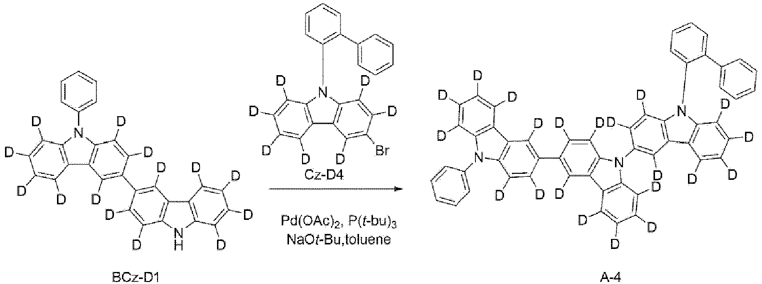

The same procedure as in Synthesis Example 1, with the exception of using Cz-D4 (10.0 g, 23.6 mmol) obtained in Preparation Example 1-4 instead of Cz-D1, was conducted to afford the target compound A-4 (12.2 g, yield 69%).

Mass (Calcd.: 747.02, Found: 747 g/mol)

### [SYNTHESIS EXAMPLE 5] Synthesis of A-5

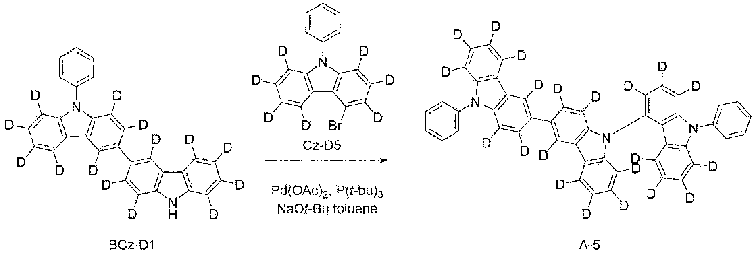

The same procedure as in Synthesis Example 1, with the exception of using Cz-D5 obtained in Preparation Example 2-1 instead of Cz-D1, was conducted to afford the target compound A-5 (8.73 g, yield 55%).

Mass (Calcd.: 670.93, Found: 670 g/mol)

### [SYNTHESIS EXAMPLE 6] Synthesis of A-6

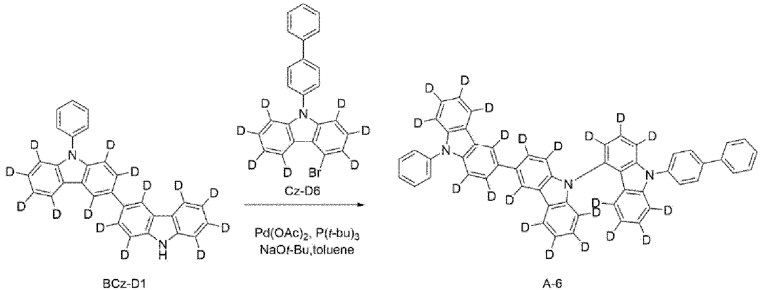

The same procedure as in Synthesis Example 1, with the exception of using Cz-D6 (10.0 g, 23.6 mmol) obtained in Preparation Example 2-2 instead of Cz-D1, was conducted to afford the target compound A-6 (7.42 g, yield 42%).

Mass (Calcd.: 747.02, Found: 747 g/mol)

### [SYNTHESIS EXAMPLE 7] Synthesis of A-7

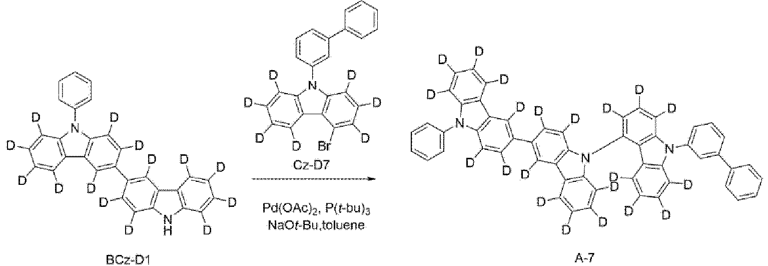

The same procedure as in Synthesis Example 1, with the exception of using Cz-D7 (10.0 g, 23.6 mmol) obtained in Preparation Example 2-3 instead of Cz-D1, was conducted to afford the target compound A-7 (8.83 g, yield 50%).

Mass (Calcd.: 747.02, Found: 747 g/mol)

### [SYNTHESIS EXAMPLE 8] Synthesis of A-8

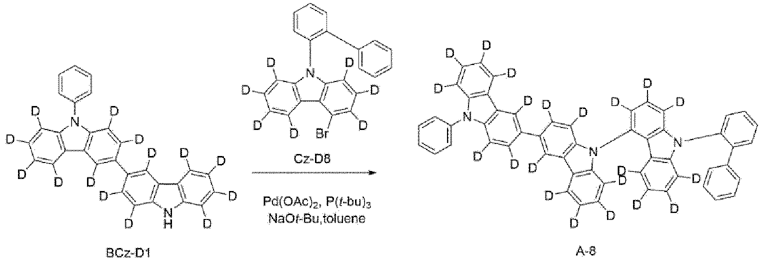

The same procedure as in Synthesis Example 1, with the exception of using Cz-D8 (10.0 g, 23.6 mmol) obtained in Preparation Example 2-4 instead of Cz-D1, was conducted to afford the target compound A-8 (9.89 g, yield 56%).

Mass (Calcd.: 747.02, Found: 747 g/mol)

### [SYNTHESIS EXAMPLE 9] Synthesis of A-9

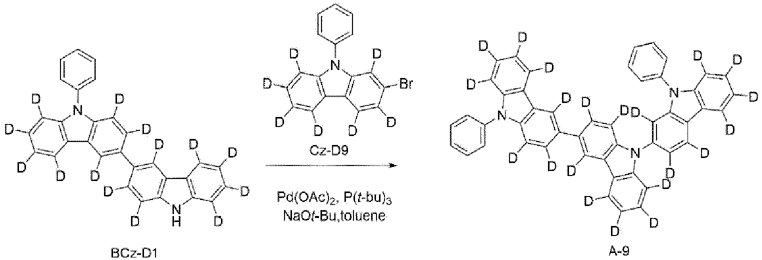

The same procedure as in Synthesis Example 1, with the exception of using Cz-D9 (9.3 g, 23.6 mmol) obtained in Preparation Example 3-1 instead of Cz-D1, was conducted to afford the target compound A-9 (8.41 g, yield 53%).

Mass (Calcd.: 670.93, Found: 670 g/mol)

### [SYNTHESIS EXAMPLE 10] Synthesis of A-10

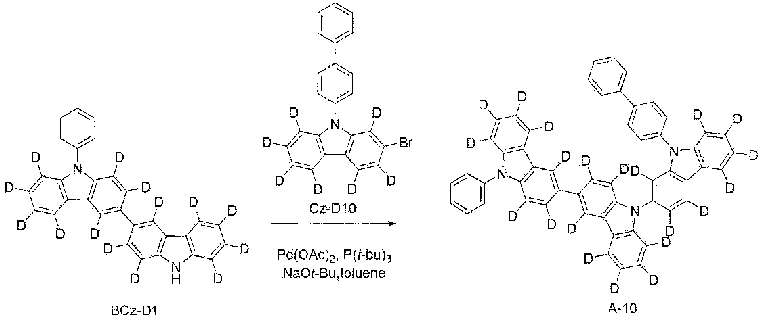

The same procedure as in Synthesis Example 1, with the exception of using Cz-D10 (10.0 g, 23.6 mmol) obtained in Preparation Example 3-2 instead of Cz-D1, was conducted to afford the target compound A-10 (8.66 g, yield 49%).

Mass (Calcd.: 747.02, Found: 747 g/mol)

### [SYNTHESIS EXAMPLE 11] Synthesis of A-11

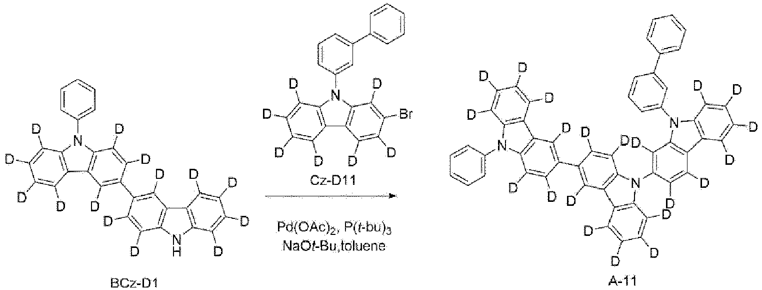

The same procedure as in Synthesis Example 1, with the exception of using Cz-D11 (10.0 g, 23.6 mmol) obtained in Preparation Example 3-3 instead of Cz-D1, was conducted to afford the target compound A-11 (9.01 g, yield 51%).

Mass (Calcd.: 747.02, Found: 747 g/mol)

### [SYNTHESIS EXAMPLE 12] Synthesis of A-12

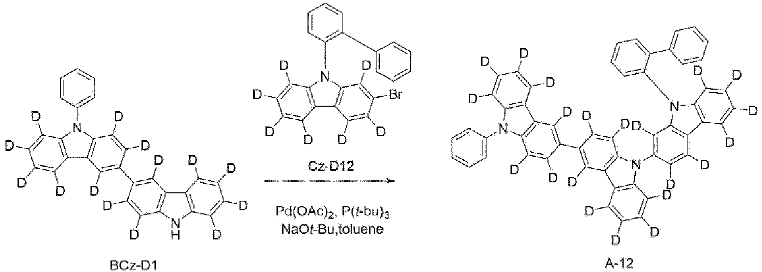

The same procedure as in Synthesis Example 1, with the exception of using Cz-D12 (10.0 g, 23.6 mmol) obtained in Preparation Example 3-4 instead of Cz-D1, was conducted to afford the target compound A-12 (9.19 g, yield 52%).

Mass (Calcd.: 747.02, Found: 747 g/mol)

### [SYNTHESIS EXAMPLE 13] Synthesis of A-13

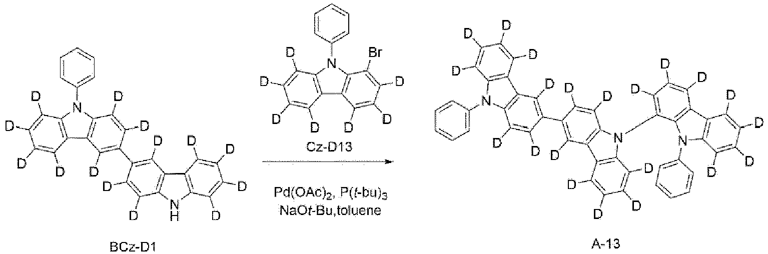

The same procedure as in Synthesis Example 1, with the exception of using Cz-D13 (9.3 g, 23.6 mmol) obtained in Preparation Example 4-1 instead of Cz-D1, was conducted to afford the target compound A-13 (9.52 g, yield 60%).

Mass (Calcd.: 670.93, Found: 670 g/mol)

### [SYNTHESIS EXAMPLE 14] Synthesis of A-14

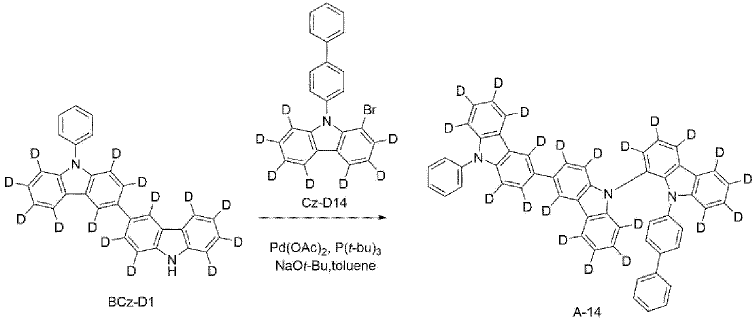

The same procedure as in Synthesis Example 1, with the exception of using Cz-D14 (10.0 g, 23.6 mmol) obtained in Preparation Example instead of Cz-D1, was conducted to afford the target compound A-14 (10.78 g, yield 61%).

Mass (Calcd.: 747.02, Found: 747 g/mol)

### [SYNTHESIS EXAMPLE 15] Synthesis of A-15

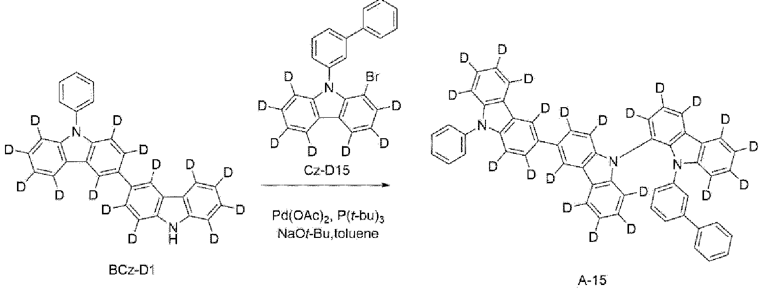

The same procedure as in Synthesis Example 1, with the exception of using Cz-D15 (10.0 g, 23.6 mmol) obtained in Preparation Example 4-3 instead of Cz-D1, was conducted to afford the target compound A-15 (11.13 g, yield 63%).

Mass (Calcd.: 747.02, Found: 747 g/mol)

### [SYNTHESIS EXAMPLE 16] Synthesis of A-16

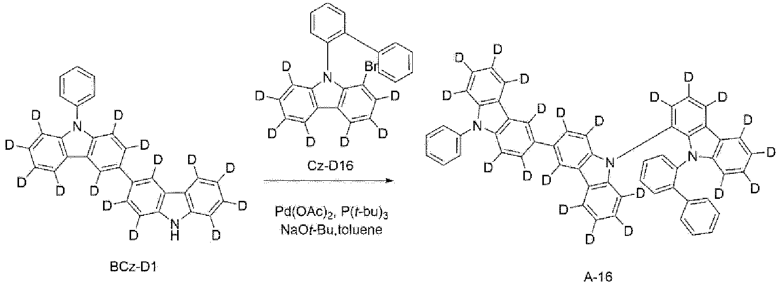

The same procedure as in Synthesis Example 1, with the exception of using Cz-D16 (10.0 g, 23.6 mmol) obtained in Preparation Example instead of Cz-D1, was conducted to afford the target compound A-16 (9.02 g, yield 51%).

Mass (Calcd.: 747.02, Found: 747 g/mol)

### [SYNTHESIS EXAMPLE 17] B-1

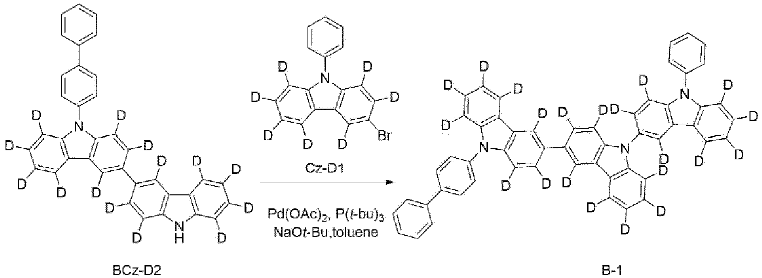

Under a nitrogen atmosphere, BCz-D2 (10.0 g, 20.1 mmol) obtained in Preparation Example 5-2, Cz-D1 (7.9 g, 24.1 mmol) obtained in Preparation Example 1-1, Pd(OAc)₂ (1.15 g, 1.0 mmol), P(*t*-Bu)₃ (0.49 ml, 2.0 mmol), NaO(*t-*Bu) (3.85 g, 40.1 mmol), and toluene (100 ml) were mixed and stirred at 110°C for 5 hours. After completion of the reaction, the toluene was concentrated and the solid salt was filtered, followed by filtration through recrystallization to afford the target compound B-1 (10.2 g, yield 62%).

Mass (Calcd.: 747.02, Found: 747 g/mol)

### [SYNTHESIS EXAMPLE 18] B-2

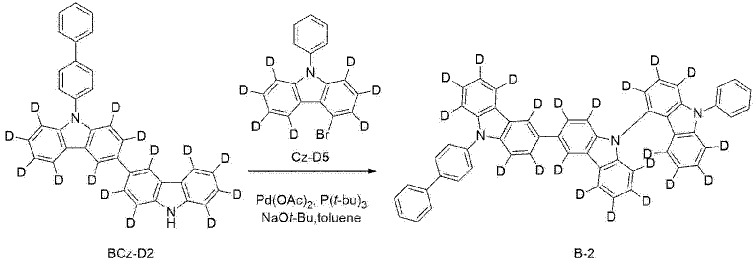

The same procedure as in Synthesis Example 17, with the exception of using Cz-D5 (7.9 g, 24.1 mmol) obtained in Preparation Example instead of Cz-D1, was conducted to afford the target compound B-2 (8.5 g, yield 48%).

Mass (Calcd.: 747.02, Found: 747 g/mol)

### [SYNTHESIS EXAMPLE 19] B-3

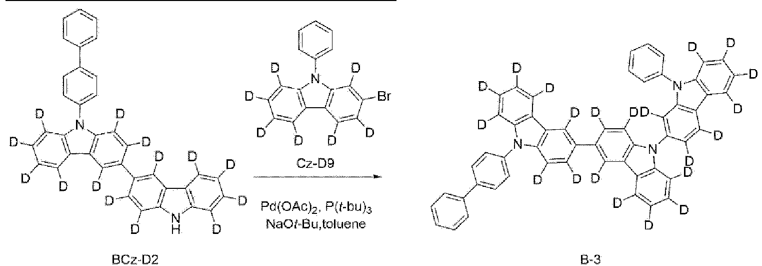

The same procedure as in Synthesis Example 17, with the exception of using Cz-D9 (7.9 g, 24.1 mmol) obtained in Preparation Example 3-1 instead of Cz-D1, was conducted to afford the target compound B-3 (11.1 g, yield 63%).

Mass (Calcd.: 747.02, Found: 747 g/mol)

### [SYNTHESIS EXAMPLE 20] B-4

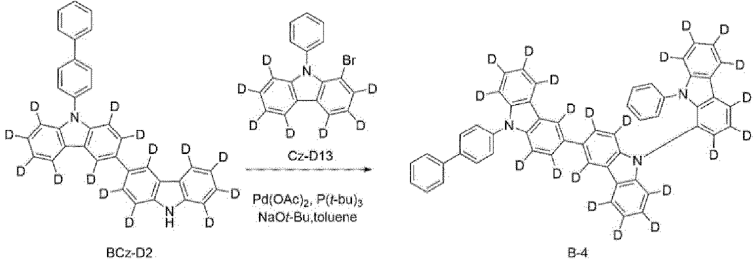

The same procedure as in Synthesis Example 17, with the exception of using Cz-D13 (7.9 g, 24.1 mmol) obtained in Preparation Example instead of Cz-D1, was conducted to afford the target compound B-4 (7.42 g, yield 42%).

Mass (Calcd.: 747.02, Found: 747 g/mol)

### [SYNTHESIS EXAMPLE 21] C-1

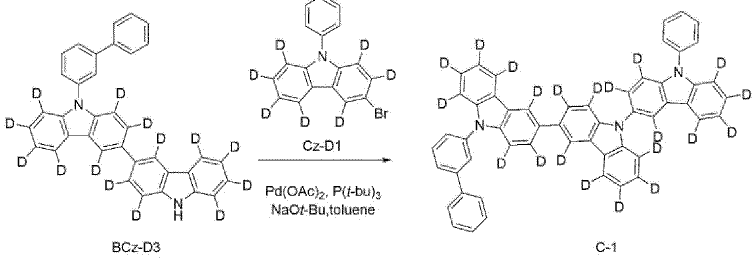

Under a nitrogen atmosphere, BCz-D3 (10.0 g, 20.1 mmol) obtained in Preparation Example 5-3, Cz-D1 (7.9 g, 24.1 mmol) obtained in Preparation Example 1-1, Pd(OAc)₂ (1.15 g, 1.0 mmol), P(*t*-Bu)₃ (0.49 ml, 2.0 mmol), NaO(*t-*Bu) (3.85 g, 40.1 mmol), and toluene (100 ml) were mixed and stirred at 110°C for 5 hours. After completion of the reaction, the toluene was concentrated and the solid salt was filtered, followed by filtration through recrystallization to afford the target compound C-1 (9.4 g, yield 63%).

Mass (Calcd.: 747.02, Found: 747 g/mol)

### [SYNTHESIS EXAMPLE 22] C-2

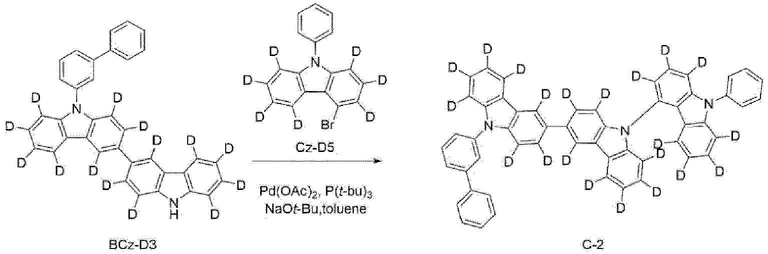

The same procedure as in Synthesis Example 21, with the exception of using Cz-D5 (7.9 g, 24.1 mmol) obtained in Preparation Example instead of Cz-D1, was conducted to afford the target compound C-2 (7.78 g, yield 44%).

Mass (Calcd.: 747.02, Found: 747 g/mol)

### [SYNTHESIS EXAMPLE 23] C-3

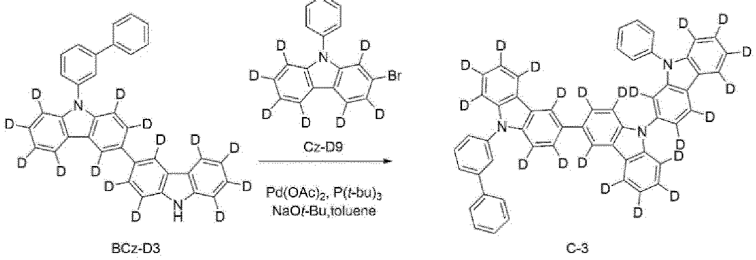

The same procedure as in Synthesis Example 21, with the exception of using Cz-D9 (7.9 g, 24.1 mmol) obtained in Preparation Example 3-1 instead of Cz-D1, was conducted to afford the target compound C-3 (11.67 g, yield 66%).

Mass (Calcd.: 747.02, Found: 747 g/mol)

### [SYNTHESIS EXAMPLE 24] C-4

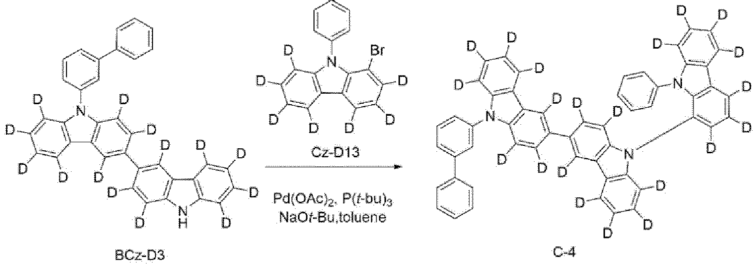

The same procedure as in Synthesis Example 21, with the exception of using Cz-D13 (7.9 g, 24.1 mmol) obtained in Preparation Example 4-1 instead of Cz-D1, was conducted to afford the target compound C-4 (6.89 g, yield 39%).

Mass (Calcd.: 747.02, Found: 747 g/mol)

### [SYNTHESIS EXAMPLE 25] Synthesis of D-1

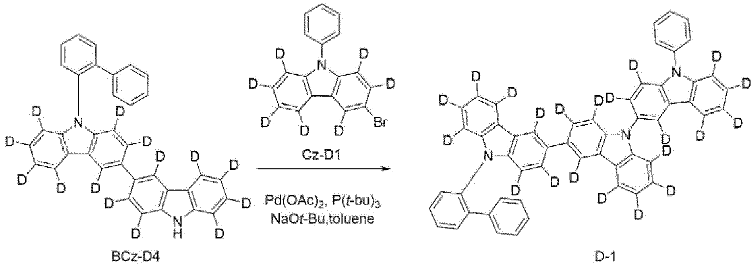

Under a nitrogen atmosphere, BCz-D4 (10.0 g, 20.1 mmol) obtained in Preparation Example 5-4, Cz-D1 (7.9 g, 24.1 mmol) obtained in Preparation Example 1-1, Pd(OAc)₂ (1.15 g, 1.0 mmol), P(*t*-Bu)₃ (0.49 ml, 2.0 mmol), NaO(*t-*Bu) (3.85 g, 40.1 mmol), and toluene (100 ml) were mixed and stirred at 110°C for 5 hours. After completion of the reaction, the toluene was concentrated and the solid salt was filtered, followed by filtration through recrystallization to afford the target compound D-1 (8.1 g, yield 54%).

Mass (Calcd.: 747.02, Found: 747 g/mol)

### [SYNTHESIS EXAMPLE 26] Synthesis of D-2

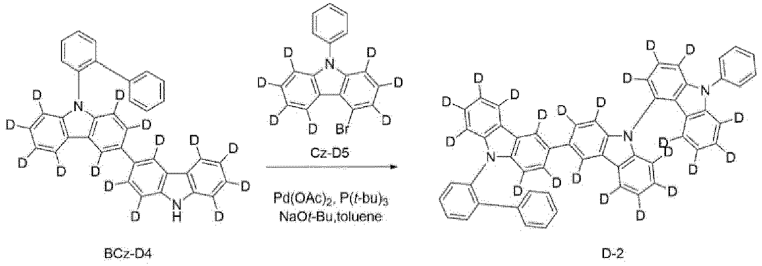

The same procedure as in Synthesis Example 25, with the exception of using Cz-D5 (7.9 g, 24.1 mmol) obtained in Preparation Example 2-1 instead of Cz-D1, was conducted to afford the target compound D-2 (7.24 g, yield 41%).

Mass (Calcd.: 747.02, Found: 747 g/mol)

### [SYNTHESIS EXAMPLE 27] Synthesis of D-3

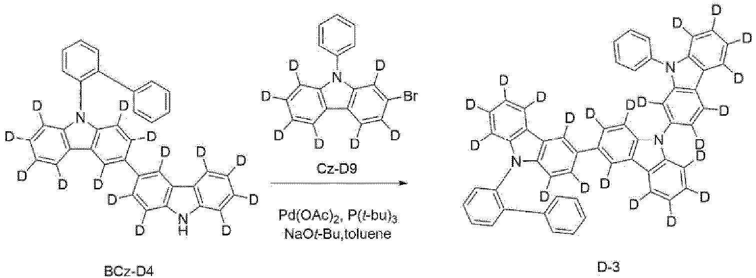

The same procedure as in Synthesis Example 25, with the exception of using Cz-D9 (7.9 g, 24.1 mmol) obtained in Preparation Example 3-1 instead of Cz-D1, was conducted to afford the target compound D-3 (8.41 g, yield 51%).

Mass (Calcd.: 747.02, Found: 747 g/mol)

### [SYNTHESIS EXAMPLE 28] Synthesis of D-4

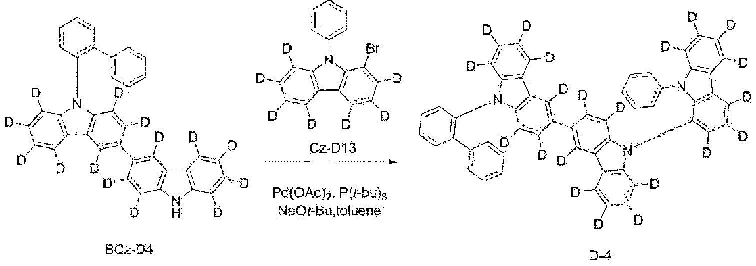

The same procedure as in Synthesis Example 25, with the exception of using Cz-D13 (7.9 g, 24.1 mmol) obtained in Preparation Example 4-1 instead of Cz-D1, was conducted to afford the target compound D-4 (5.47 g, yield 31%).

Mass (Calcd.: 747.02, Found: 747 g/mol)

### [PREPARATION EXAMPLE 6] Synthesis of DBF-1

### <Step 1> Synthesis of 4-(3-chlorophenyl)-6-phenyldibenzo[b,d]furan

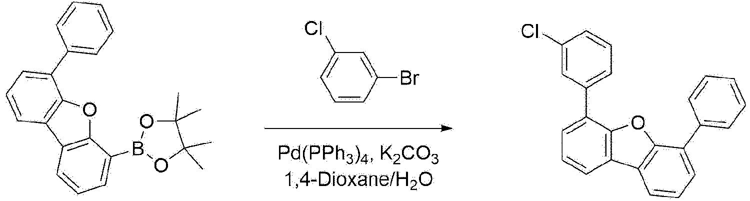

Under a nitrogen atmosphere, 4,4,5,5-tetramethyl-2-(6-phenyldibenzo[b,d]furan-4-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 4-(3-chlorophenyl)-6-phenyldibenzo[b,d]furan (48.9 g, yield 51%).

Mass (Calcd.: 354.83, Found: 354 g/mol)

### <Step 2> Synthesis of DBF-1

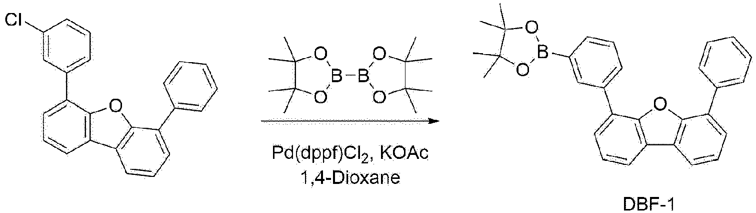

Under a nitrogen atmosphere, 4-(3-chlorophenyl)-6-phenyldibenzo[b,d]furan (48.9 g, 137.7 mmol) obtained in <step 1>, 4,4,4',4',5,5, 5',5'-octamethyl-2,2'-bi(1,3,2-dioxaborolane) (38.5 g, 151.5 mmol), Pd(dppf)Cl₂ (12.1 g, 13.8 mmol), KOAc (38.9 g, 413.2 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane:DCM = 4:1 (v/v)) to afford DBF-1 (26.4 g, yield 43%).

Mass (Calcd.: 446.35, Found: 446 g/mol)

### [PREPARATION EXAMPLE 7] Synthesis of DBF-2

### <Step 1> Synthesis of 4-(4-chlorophenyl)-6-phenyldibenzo[b,d]furan

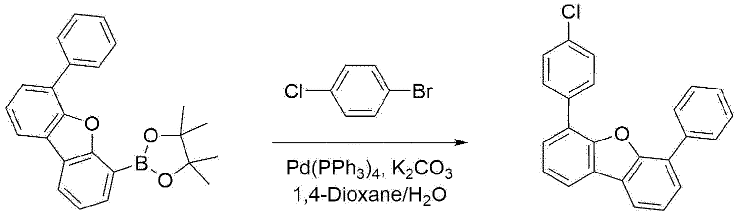

Under a nitrogen atmosphere, 4,4,5,5-tetramethyl-2-(6-phenyldibenzo[b,d]furan-4-yl)-1,3,2-dioxaborolane (100.0 g, 270.0 mmol), 1-bromo-4-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 4-(4-chlorophenyl)-6-phenyldibenzo[b,d]furan (60.4 g, yield 63%) .

Mass (Calcd.: 354.83, Found: 354 g/mol)

### <Step 2> Synthesis of DBF-2

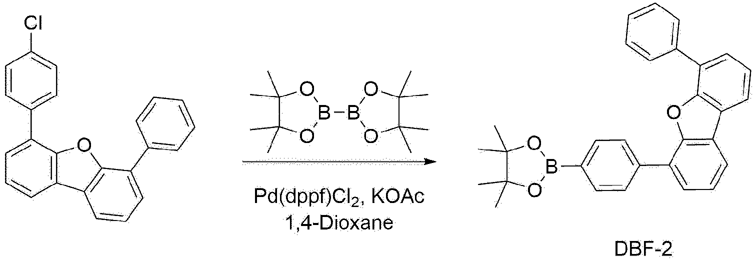

Under a nitrogen atmosphere, 4-(4-chlorophenyl)-6-phenyldibenzo[b,d]furan (60.4 g, 170.2 mmol) obtained in <step 1> , 4,4,4',4',5,5, 5',5'-octamethyl-2,2'-bi(1,3,2-dioxaborolane) (47.5 g, 187.2 mmol), Pd(dppf)Cl₂ (14.9 g, 17.0 mmol), KOAc (48.1 g, 510.4 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄, followed by purification by column chromatography (Hexane:DCM = 4:1 (v/v)) to afford DBF-2 (36.5 g, yield 48%).

Mass (Calcd.: 446.35, Found: 446 g/mol)

### [PREPARATION EXAMPLE 8] Synthesis of DBF-3

### <Step 1> Synthesis of 3-(3-chlorophenyl)-6-phenyldibenzo[b,d]furan

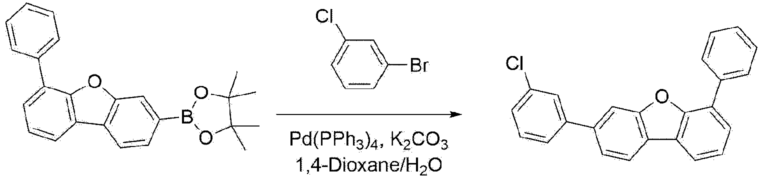

Under a nitrogen atmosphere, 4,4,5,5-tetramethyl-2-(6-phenyldibenzo[b,d]furan-3-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 3-(3-chlorophenyl)-6-phenyldibenzo[b,d]furan (68.0 g, yield 71%).

Mass (Calcd.: 354.83, Found: 354 g/mol)

### <Step 2> Synthesis of DBF-3

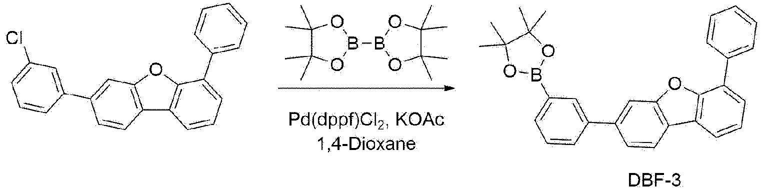

Under a nitrogen atmosphere, 3-(3-chlorophenyl)-6-phenyldibenzo[b,d]furan (68.0 g, 191.8 mmol) obtained in <step 1>, 4,4,4',4',5,5, 5',5'-octamethyl-2,2'-bi(1,3,2-dioxaborolane) (53.6 g, 210.9 mmol), Pd(dppf)Cl₂ (16.8 g, 19.2 mmol), KOAc (54.2 g, 575.3 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane: DCM = 4:1 (v/v)) to afford DBF-3 (54.8 g, yield 64%).

Mass (Calcd.: 446.35, Found: 446 g/mol)

### [PREPARATION EXAMPLE 9] Synthesis of DBF-4

### <Step 1> Synthesis of 1-(3-chlorophenyl)-6-phenyldibenzo[b,d]furan

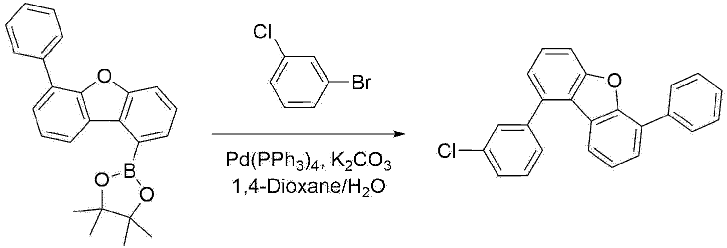

Under a nitrogen atmosphere, 4,4,5,5-tetramethyl-2-(6-phenyldibenzo[b,d]furan-1-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 1-(3-chlorophenyl)-6-phenyldibenzo[b,d]furan (62.3 g, yield 65%) .

Mass (Calcd.: 354.83, Found: 354 g/mol)

### <Step 2> Synthesis of DBF-4

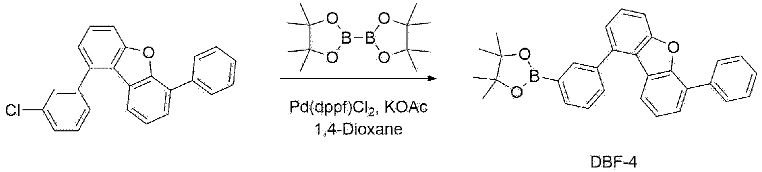

Under a nitrogen atmosphere, 1-(3-chlorophenyl)-6-phenyldibenzo[b,d]furan (62.3 g, 175.6 mmol) obtained in <step 1>, 4,4,4',4',5,5, 5',5'-octamethyl-2,2'-bi(1,3,2-dioxaborolane) (49.0 g, 193.1 mmol), Pd(dppf)Cl₂ (15.4 g, 17.6 mmol), KOAc (49.6 g, 526.7 mmol), and 1,4-Dioxane (1000 ml) were mixed and stirred at 130°C for 12 hours.

After completion of the reaction, the reaction mixture was subjected to extraction with ethyl acetate and the extract was dried over MgSO₄. Purification by column chromatography (Hexane:DCM = 4:1 (v/v)) afforded DBF-4 (45.4 g, yield 58%).

Mass (Calcd.: 446.35, Found: 446 g/mol)

### [PREPARATION EXAMPLE 10] Synthesis of DBF-5

### <Step 1> Synthesis of 1-(3-chlorophenyl)-9-phenyldibenzo[b,d]furan

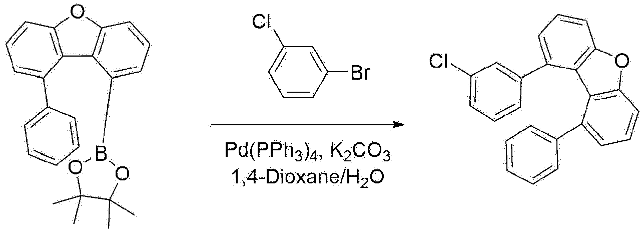

Under a nitrogen atmosphere, 4,4,5,5-tetramethyl-2-(9-phenyldibenzo[b,d]furan-1-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:DCM = 9:1 (v/v)) to afford 1-(3-chlorophenyl)-9-phenyldibenzo[b,d]furan (68.0 g, yield 71%).

Mass (Calcd.: 354.83, Found: 354 g/mol)

### <Step 2> Synthesis of DBF-5

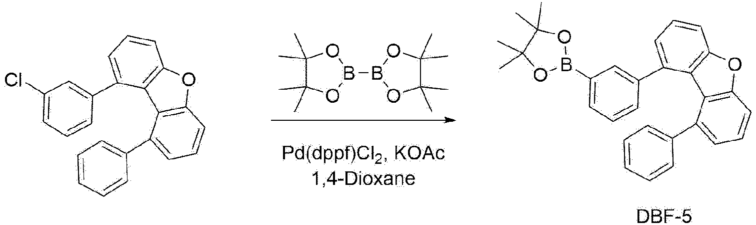

Under a nitrogen atmosphere, 1-(3-chlorophenyl)-9-phenyldibenzo[b,d]furan (68.0 g, 191.8 mmol) obtained in <step 1>, 4,4,4',4',5,5, 5',5'-octamethyl-2,2'-bi(1,3,2-dioxaborolane) (53.6 g, 210.9 mmol), Pd(dppf)Cl₂ (16.8 g, 19.2 mmol), KOAc (54.2 g, 575.3 mmol), and 1,4-Dioxane (1000 ml) were mixed and stirred at 130°C for 12.

After completion of the reaction, the reaction mixture was subjected to extraction with ethyl acetate and the extract was dried over MgSO₄. Purification by column chromatography (Hexane:DCM = 4:1 (v/v)) afforded DBF-5 (41.9 g, yield 49%).

Mass (Calcd.: 446.35, Found: 446 g/mol)

### [SYNTHESIS EXAMPLE 29] Synthesis of E-1

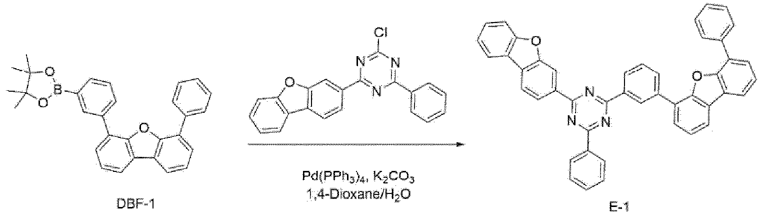

Under a nitrogen atmosphere, DBF-1 (10.0 g, 22.4 mmol) obtained in Preparation Example 6, 2-chloro-4-(dibenzo[b,d]furan-3-yl)-6-phenyl-1,3,5-triazine (9.6 g, 26.9 mmol), Pd(PPh₃)₄ (1.3 g, 1.1 mmol), K₂CO₃ (7.7 g, 56.0 mmol), and 1,4-dioxane/H₂O (1000 ml/250 ml) were mixed and stirred at 120°C for 4 hours.

After completion of the reaction, the reaction mixture was subjected to extraction with methylene chloride and the extract was added with MgSO₄ and filtered. The solvent was removed from the organic layer thus obtained, followed by purification by column chromatography (Hexane:EA = 4:1 (v/v)) to afford the target compound E-1 (11.8 g, yield 82%).

Mass (Calcd.: 641.73, Found: 641 g/mol)

### [SYNTHESIS EXAMPLE 30] Synthesis of E-2

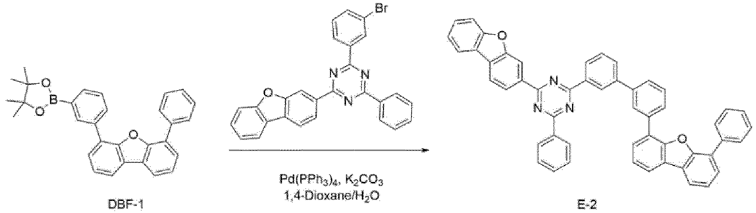

The same procedure as in Synthesis Example 29, with the exception of using 2-(3-bromophenyl)-4-(dibenzo[b,d]furan-3-yl)-6-phenyl-1,3,5-triazine (12.9 g, 26.9 mmol) instead of 2-chloro-4-(dibenzo[b,d]furan-3-yl)-6-phenyl-1,3,5-triazine, was conducted to afford the target compound E-2 (11.9 g, yield 74%).

Mass (Calcd.: 717.83, Found: 717 g/mol)

### [SYNTHESIS EXAMPLE 31] Synthesis of E-3

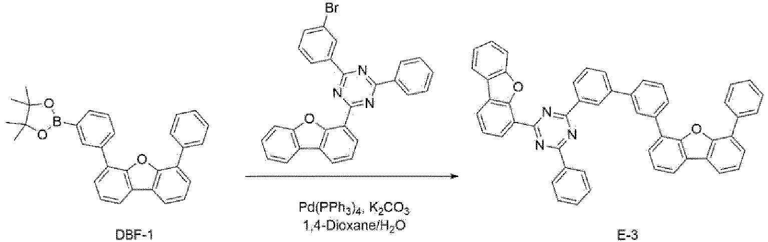

The same procedure as in Synthesis Example 29, with the exception of using 2-(3-bromophenyl)-4-(dibenzo[b,d]furan-4-yl)-6-phenyl-1,3,5-triazine (12.9 g, 26.9 mmol) instead of 2-chloro-4-(dibenzo[b,d]furan-3-yl)-6-phenyl-1,3,5-triazine, was conducted to afford the target compound E-3 (11.4 g, yield 71%).

Mass (Calcd.: 717.83, Found: 717 g/mol)

### [SYNTHESIS EXAMPLE 32] Synthesis of E-4

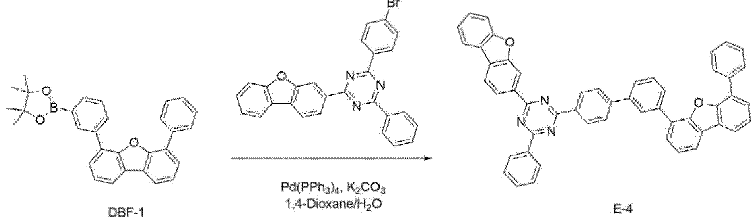

The same procedure as in Synthesis Example 29, with the exception of using 2-(4-bromophenyl)-4-(dibenzo[b,d]furan-3-yl)-6-phenyl-1,3,5-triazine (12.9 g, 26.9 mmol) instead of 2-chloro-4-(dibenzo[b,d]furan-3-yl)-6-phenyl-1,3,5-triazine, was conducted to afford the target compound E-4 (12.7 g, yield 79%).

Mass (Calcd.: 717.83, Found: 717 g/mol)

### [SYNTHESIS EXAMPLE 33] Synthesis of E-5

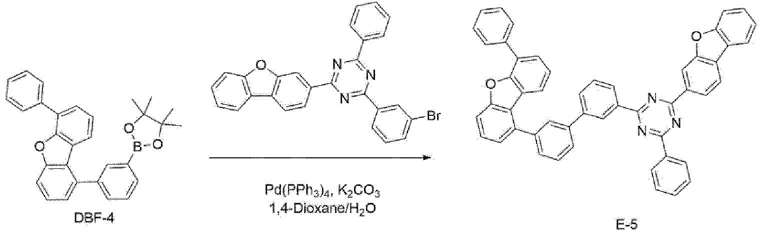

The same procedure as in Synthesis Example 29, with the exception of using DBF-4 (10.0 g, 22.4 mmol) obtained in Preparation Example 9 and 2-(3-bromophenyl)-4-(dibenzo[b,d]furan-3-yl)-6-phenyl-1,3,5-triazine (12.9 g, 26.9 mmol) instead of DBF-1 (10.0 g, 22.4 mmol) and 2-chloro-4-(dibenzo[b,d]furan-3-yl)-6-phenyl-1,3,5-triazine, respectively, was conducted to afford the target compound E-5 (9.8 g, yield 61%).

Mass (Calcd.: 717.83, Found: 717 g/mol)

### [SYNTHESIS EXAMPLE 34] Synthesis of E-6

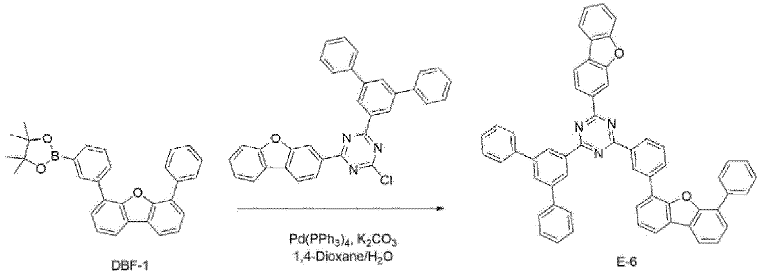

The same procedure as in Synthesis Example 29, with the exception of using 2-([1,1':3',1"-terphenyl]-5'-yl)-4-chloro-6-(dibenzo[b,d]furan-3-yl)-1,3,5-triazine (13.7 g, 26.9 mmol) instead of 2-chloro-4-(dibenzo[b,d]furan-3-yl)-6-phenyl-1,3,5-triazine, was conducted to afford the target compound E-6 (9.6 g, yield 54%).

Mass (Calcd.: 793.93, Found: 793 g/mol)

### [SYNTHESIS EXAMPLE 35] Synthesis of E-7

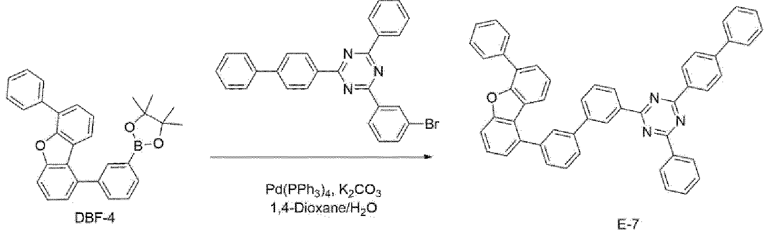

The same procedure as in Synthesis Example 29, with the exception of using DBF-4 (10.0 g, 22.4 mmol) obtained in Preparation Example 9 and 2-([1,1'-biphenyl]-4-yl)-4-(3-bromophenyl)-6-phenyl-1,3,5-triazine (12.5 g, 26.9 mmol) instead of DBF-1 (10.0 g, 22.4 mmol) and 2-chloro-4-(dibenzo[b,d]furan-3-yl)-6-phenyl-1,3,5-triazine, respectively, was conducted to afford the target compound E-7 (9.8 g, yield 62%).

Mass (Calcd.: 703.85, Found: 703 g/mol)

### [SYNTHESIS EXAMPLE 36] Synthesis of E-8

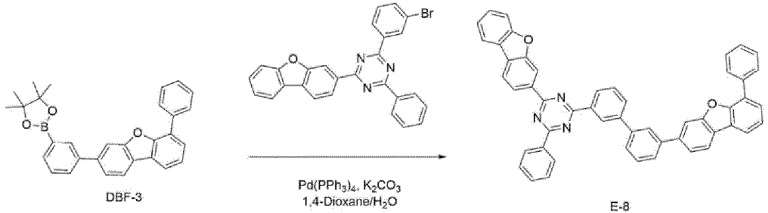

The same procedure as in Synthesis Example 29, with the exception of using DBF-3 (10.0 g, 22.4 mmol) obtained in Preparation Example 8 and 2-(3-bromophenyl)-4-(dibenzo[b,d]furan-3-yl)-6-phenyl-1,3,5-triazine (12.9 g, 26.9 mmol) instead of DBF-1 (10.0 g, 22.4 mmol) and 2-chloro-4-(dibenzo[b,d]furan-3-yl)-6-phenyl-1,3,5-triazine, was conducted to afford the target compound E-8 (10.8 g, yield 67%).

Mass (Calcd.: 717.83, Found: 717 g/mol)

### [SYNTHESIS EXAMPLE 37] Synthesis of E-9

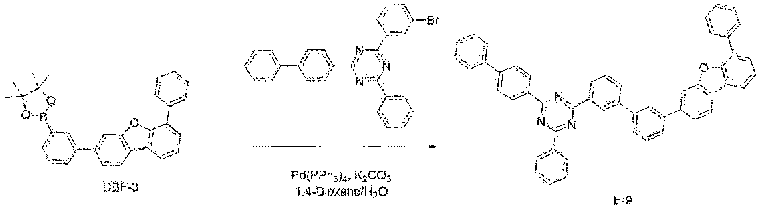

The same procedure as in Synthesis Example 29, with the exception of using DBF-3 (10.0 g, 22.4 mmol) obtained in Preparation Example 8 and 2-([1,1'-biphenyl]-4-yl)-4-(3-bromophenyl)-6-phenyl-1,3,5-triazine (12.5 g, 26.9 mmol) instead of DBF-1 (10.0 g, 22.4 mmol) and 2-chloro-4-(dibenzo[b,d]furan-3-yl)-6-henyl-1,3,5-triazine, respectively, was conducted to afford the target compound E-9 (11.4 g, yield 72%).

Mass (Calcd.: 703.85, Found: 703 g/mol)

### [SYNTHESIS EXAMPLE 38] Synthesis of E-10

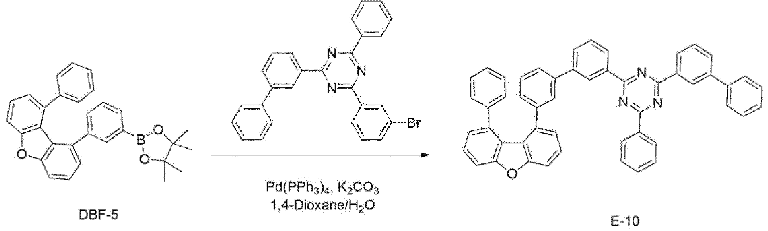

The same procedure as in Synthesis Example 29, with the exception of using DBF-5 (10.0 g, 22.4 mmol) obtained in Preparation Example and 2-([1,1'-biphenyl]-3-yl)-4-(3-bromophenyl)-6-phenyl-1,3,5-triazine (12.5 g, 26.9 mmol) instead of DBF-1 (10.0 g, 22.4 mmol) and 2-chloro-4-(dibenzo[b,d]furan-3-yl)-6-phenyl-1,3,5-triazine, respectively, was conducted to afford the target compound E-10 (10.4 g, yield 66%).

Mass (Calcd.: 703.85, Found: 703 g/mol)

### [EXAMPLE 1] - Preparation of Pellet P1 and

### Fabrication of Green Organic EL Device

Compound A-1 with hole characteristics and compound E-1 with electron characteristic were uniformly mixed at a 6:4 weight ratio, and then the mixture was pelletized under a pressure of 20,000 kgf/cm² to obtain pellet P1, as shown in FIG. 1(a). Using this pellet, a green organic EL device was fabricated as described below. In this regard, compound A-1 with hole characteristics was synthesized in Synthesis Example 1, and compound E-1 with electron characteristics was synthesized in Synthesis Example 29.

First, a glass substrate coated with indium tin oxide (ITO) 1500 Å thick was cleansed using ultrasonic waves in distilled water. After the distilled water cleansing, the substrate was ultrasonically cleansed using solvents such as isopropyl alcohol, acetone, and methanol, dried, and transferred to a UV OZONE cleaner (Power Sonic 405, Hwashin Tech), where it was treated with UV for 5 minutes. The cleaned substrate was then transferred to a vacuum deposition system.

On the prepared ITO transparent electrode, the following layers were sequentially deposited: m-MTDATA (60 nm)/TCTA (80 nm)/90 wt% Pellet P1 + 10 wt% Ir(ppy)₃ (300 nm)/BCP (10 nm)/Alq₃ (30 nm)/LiF (1 nm) /Al (200 nm), thereby fabricating the organic EL device.

The structures of m-MTDATA, TCTA, Ir(ppy)₃, and BCP are as follows:

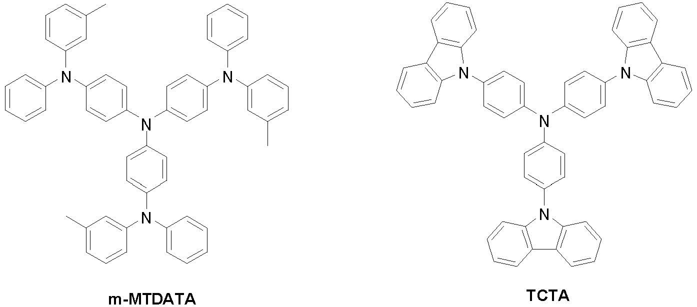

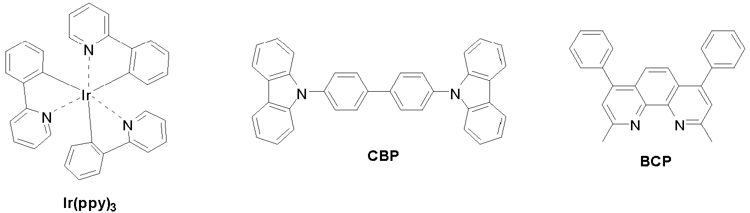

### [EXAMPLES 2 TO 280] - Preparation of Pellets P2 to P280 and Fabrication of Green Organic EL Devices

The same procedure as in Example 1, with the exception of using compounds A-2 to D-4 listed in Table 2, instead of compound A-1, as the first organic compound and compounds E-2 to E-10 listed in Table 2, instead of compound E-1, as the second compound, was conducted to prepare pellets P2 to P280 and fabricate green organic EL devices. In this regard, the mixing ratio of the first and second organic compounds was the same as that of compound A-1 and compound E-1 in Example 1.

### [EXAMPLES 2 TO 280] - Preparation of Pellet P281 and Fabrication of Green Organic EL Device

The same procedure as in Example 1, with the exception of mixing compounds A-1 and E-1 at a weight ratio of 5:5, to prepare pellet P281, and a green organic EL device was fabricated using same.

### [EXAMPLE 3] - Preparation of Pellet P282 and Fabrication of Green Organic EL Device

The same procedure as in Example 1, with the exception of mixing compounds A-1 and E-1 at a weight ratio of 7:3, to prepare pellet P282, and a green organic EL device was fabricated using same.

### [COMPARATIVE EXAMPLE 1] - Fabrication of Green Organic EL Device

The same procedure as in Example 1, with the exception of using a simple mixture comA-1 of compounds A-1 and E-1 (compound A-1 : compound E-1 = 6:4 weight ratio) instead of pellet P1, was conducted to fabricate a green organic EL device. In this regard, unlike pellet P1, the simple mixture comA-1 was a uniform mixture of compounds A-1 and E-1 without being compressed into a pellet under high pressure. The compounds A-1 and E-1 used were the same as those described in Example 1.

### [COMPARATIVE EXAMPLE 2] - Fabrication of Green Organic EL Device

The same procedure as in Comparative Example 1, with the exception of mixing using compounds A-1 and E-1 at a weight ratio of 5:5, to prepare a simple mixture comB, and a green organic EL device was fabricated using same.

### [COMPARATIVE EXAMPLE 3] - Fabrication of Green Organic EL Device

The same procedure as in Example 1, with the exception of mixing compounds A-1 and E-1 at a weight ratio of 7:3, to prepare a simple mixture comC, and a green organic EL device was fabricated using same.

### [EXPERIMENTAL EXAMPLE 1] - Measurement of Maximum Emission Wavelength of Pellets

Pellets P1 to P280, prepared in Examples 1 to 280, were made into films, and their maximum emission wavelengths were measured. The results are given in Table 1. In this regard, the maximum emission wavelengths of the raw materials (compounds A-1 to D-4 and compounds E-1 to E-10) used for each pellet were also measured, and for comparison, the maximum emission wavelength of the simple mixture comA in Comparative Example 1 was measured as the control.

**TABLE 1**

| | Sample | Max. Emission Wavelength (λₘₐₓ, nm) | Sample | Max. Emission Wavelength (λₘₐₓ, nm) | Sample | Max. Emission Wavelength (λₘₐₓ, nm) |
|---|---|---|---|---|---|---|
| Ex. 1 | A-1 | 380 | E-1 | 415 | Pellet P1 | 415 |
| Ex. 2 | A-1 | 380 | E-2 | 415 | Pellet P2 | 415 |
| Ex. 3 | A-1 | 380 | E-3 | 414 | Pellet P3 | 414 |
| Ex. 4 | A-1 | 380 | E-4 | 416 | Pellet P4 | 416 |
| Ex. 5 | A-1 | 380 | E-5 | 419 | Pellet P5 | 419 |
| Ex. 6 | A-1 | 380 | E-6 | 413 | Pellet P6 | 413 |
| Ex. 7 | A-1 | 380 | E-7 | 414 | Pellet P7 | 414 |
| Ex. 8 | A-1 | 380 | E-8 | 415 | Pellet P8 | 415 |
| Ex. 9 | A-1 | 380 | E-9 | 415 | Pellet P9 | 415 |
| Ex. 10 | A-1 | 380 | E-10 | 416 | Pellet P10 | 416 |
| Ex. 11 | A-2 | 378 | E-1 | 415 | Pellet P11 | 415 |
| Ex. 12 | A-2 | 378 | E-2 | 415 | Pellet P12 | 415 |
| Ex. 13 | A-2 | 378 | E-3 | 414 | Pellet P13 | 414 |
| Ex. 14 | A-2 | 378 | E-4 | 416 | Pellet P14 | 416 |
| Ex. 15 | A-2 | 378 | E-5 | 419 | Pellet P15 | 419 |
| Ex. 16 | A-2 | 378 | E-6 | 413 | Pellet P16 | 413 |
| Ex. 17 | A-2 | 378 | E-7 | 414 | Pellet P17 | 414 |
| Ex. 18 | A-2 | 378 | E-8 | 415 | Pellet P18 | 415 |
| Ex. 19 | A-2 | 378 | E-9 | 415 | Pellet P19 | 415 |
| Ex. 20 | A-2 | 378 | E-10 | 416 | Pellet P20 | 416 |
| Ex. 21 | A-3 | 377 | E-1 | 415 | Pellet P21 | 415 |
| Ex. 22 | A-3 | 377 | E-2 | 415 | Pellet P22 | 415 |
| Ex. 23 | A-3 | 377 | E-3 | 414 | Pellet P23 | 414 |
| Ex. 24 | A-3 | 377 | E-4 | 416 | Pellet P24 | 416 |
| Ex. 25 | A-3 | 377 | E-5 | 419 | Pellet P25 | 419 |
| Ex. 26 | A-3 | 377 | E-6 | 413 | Pellet P26 | 413 |
| Ex. 27 | A-3 | 377 | E-7 | 414 | Pellet P27 | 414 |
| Ex. 28 | A-3 | 377 | E-8 | 415 | Pellet P28 | 415 |
| Ex. 29 | A-3 | 377 | E-9 | 415 | Pellet P29 | 415 |
| Ex. 30 | A-3 | 377 | E-10 | 416 | Pellet P30 | 416 |
| Ex. 31 | A-4 | 380 | E-1 | 415 | Pellet P31 | 415 |
| Ex. 32 | A-4 | 380 | E-2 | 415 | Pellet P32 | 415 |
| Ex. 33 | A-4 | 380 | E-3 | 414 | Pellet P33 | 414 |
| Ex. 34 | A-4 | 380 | E-4 | 416 | Pellet P34 | 416 |
| Ex. 35 | A-4 | 380 | E-5 | 419 | Pellet P35 | 419 |
| Ex. 36 | A-4 | 380 | E-6 | 413 | Pellet P36 | 413 |
| Ex. 37 | A-4 | 380 | E-7 | 414 | Pellet P37 | 414 |
| Ex. 38 | A-4 | 380 | E-8 | 415 | Pellet P38 | 415 |
| Ex. 39 | A-4 | 380 | E-9 | 415 | Pellet P39 | 415 |
| Ex. 40 | A-4 | 380 | E-10 | 416 | Pellet P40 | 416 |
| Ex. 41 | A-5 | 382 | E-1 | 415 | Pellet P41 | 415 |
| Ex. 42 | A-5 | 382 | E-2 | 415 | Pellet P42 | 415 |
| Ex. 43 | A-5 | 382 | E-3 | 414 | Pellet P43 | 414 |
| Ex. 44 | A-5 | 382 | E-4 | 416 | Pellet P44 | 416 |
| Ex. 45 | A-5 | 382 | E-5 | 419 | Pellet P45 | 419 |
| Ex. 46 | A-5 | 382 | E-6 | 413 | Pellet P46 | 413 |
| Ex. 47 | A-5 | 382 | E-7 | 414 | Pellet P47 | 414 |
| Ex. 48 | A-5 | 382 | E-8 | 415 | Pellet P48 | 415 |
| Ex. 49 | A-5 | 382 | E-9 | 415 | Pellet P49 | 415 |
| Ex. 50 | A-5 | 382 | E-10 | 416 | Pellet P50 | 416 |
| Ex. 51 | A-6 | 376 | E-1 | 415 | Pellet P51 | 415 |
| Ex. 52 | A-6 | 376 | E-2 | 415 | Pellet P52 | 415 |
| Ex. 53 | A-6 | 376 | E-3 | 414 | Pellet P53 | 414 |
| Ex. 54 | A-6 | 376 | E-4 | 416 | Pellet P54 | 416 |
| Ex. 55 | A-6 | 376 | E-5 | 419 | Pellet P55 | 419 |
| Ex. 56 | A-6 | 376 | E-6 | 413 | Pellet P56 | 413 |
| Ex. 57 | A-6 | 376 | E-7 | 414 | Pellet P57 | 414 |
| Ex. 58 | A-6 | 376 | E-8 | 415 | Pellet P58 | 415 |
| Ex. 59 | A-6 | 376 | E-9 | 415 | Pellet P59 | 415 |
| Ex. 60 | A-6 | 376 | E-10 | 416 | Pellet P60 | 416 |
| Ex. 61 | A-7 | 381 | E-1 | 415 | Pellet P61 | 415 |
| Ex. 62 | A-7 | 381 | E-2 | 415 | Pellet P62 | 415 |
| Ex. 63 | A-7 | 381 | E-3 | 414 | Pellet P63 | 414 |
| Ex. 64 | A-7 | 381 | E-4 | 416 | Pellet P64 | 416 |
| Ex. 65 | A-7 | 381 | E-5 | 419 | Pellet P65 | 419 |
| Ex. 66 | A-7 | 381 | E-6 | 413 | Pellet P66 | 413 |
| Ex. 67 | A-7 | 381 | E-7 | 414 | Pellet P67 | 414 |
| Ex. 68 | A-7 | 381 | E-8 | 415 | Pellet P68 | 415 |
| Ex. 69 | A-7 | 381 | E-9 | 415 | Pellet P69 | 415 |
| Ex. 70 | A-7 | 381 | E-10 | 416 | Pellet P70 | 416 |
| Ex. 71 | A-8 | 381 | E-1 | 415 | Pellet P71 | 415 |
| Ex. 72 | A-8 | 381 | E-2 | 415 | Pellet P72 | 415 |
| Ex. 73 | A-8 | 381 | E-3 | 414 | Pellet P73 | 414 |
| Ex. 74 | A-8 | 381 | E-4 | 416 | Pellet P74 | 416 |
| Ex. 75 | A-8 | 381 | E-5 | 419 | Pellet P75 | 419 |
| Ex. 76 | A-8 | 381 | E-6 | 413 | Pellet P76 | 413 |
| Ex. 77 | A-8 | 381 | E-7 | 414 | Pellet P77 | 414 |
| Ex. 78 | A-8 | 381 | E-8 | 415 | Pellet P78 | 415 |
| Ex. 79 | A-8 | 381 | E-9 | 415 | Pellet P79 | 415 |
| Ex. 80 | A-8 | 381 | E-10 | 416 | Pellet P80 | 416 |
| Ex. 81 | A-9 | 381 | E-1 | 415 | Pellet P81 | 415 |
| Ex. 82 | A-9 | 381 | E-2 | 415 | Pellet P82 | 415 |
| Ex. 83 | A-9 | 381 | E-3 | 414 | Pellet P83 | 414 |
| Ex. 84 | A-9 | 381 | E-4 | 416 | Pellet P84 | 416 |
| Ex. 85 | A-9 | 381 | E-5 | 419 | Pellet P85 | 419 |
| Ex. 86 | A-9 | 381 | E-6 | 413 | Pellet P86 | 413 |
| Ex. 87 | A-9 | 381 | E-7 | 414 | Pellet P87 | 414 |
| Ex. 88 | A-9 | 381 | E-8 | 415 | Pellet P88 | 415 |
| Ex. 89 | A-9 | 381 | E-9 | 415 | Pellet P89 | 415 |
| Ex. 90 | A-9 | 381 | E-10 | 416 | Pellet P90 | 416 |
| Ex. 91 | A-10 | 378 | E-1 | 415 | Pellet P91 | 415 |
| Ex. 92 | A-10 | 378 | E-2 | 415 | Pellet P92 | 415 |
| Ex. 93 | A-10 | 378 | E-3 | 414 | Pellet P93 | 414 |
| Ex. 94 | A-10 | 378 | E-4 | 416 | Pellet P94 | 416 |
| Ex. 95 | A-10 | 378 | E-5 | 419 | Pellet P95 | 419 |
| Ex. 96 | A-10 | 378 | E-6 | 413 | Pellet P96 | 413 |
| Ex. 97 | A-10 | 378 | E-7 | 414 | Pellet P97 | 414 |
| Ex. 98 | A-10 | 378 | E-8 | 415 | Pellet P98 | 415 |
| Ex. 99 | A-10 | 378 | E-9 | 415 | Pellet P99 | 415 |
| Ex. 100 | A-10 | 378 | E-10 | 416 | Pellet P100 | 416 |
| Ex. 101 | A-11 | 381 | E-1 | 415 | Pellet P101 | 415 |
| Ex. 102 | A-11 | 381 | E-2 | 415 | Pellet P102 | 415 |
| Ex. 103 | A-11 | 381 | E-3 | 414 | Pellet P103 | 414 |
| Ex. 104 | A-11 | 381 | E-4 | 416 | Pellet P104 | 416 |
| Ex. 105 | A-11 | 381 | E-5 | 419 | Pellet P105 | 419 |
| Ex. 106 | A-11 | 381 | E-6 | 413 | Pellet P106 | 413 |
| Ex. 107 | A-11 | 381 | E-7 | 414 | Pellet P107 | 414 |
| Ex. 108 | A-11 | 381 | E-8 | 415 | Pellet P108 | 415 |
| Ex. 109 | A-11 | 381 | E-9 | 415 | Pellet P109 | 415 |
| Ex. 110 | A-11 | 381 | E-10 | 416 | Pellet P110 | 416 |
| Ex. 111 | A-12 | 384 | E-1 | 415 | Pellet P111 | 415 |
| Ex. 112 | A-12 | 384 | E-2 | 415 | Pellet P112 | 415 |
| Ex. 113 | A-12 | 384 | E-3 | 414 | Pellet P113 | 414 |
| Ex. 114 | A-12 | 384 | E-4 | 416 | Pellet P114 | 416 |
| Ex. 115 | A-12 | 384 | E-5 | 419 | Pellet P115 | 419 |
| Ex. 116 | A-12 | 384 | E-6 | 413 | Pellet P116 | 413 |
| Ex. 117 | A-12 | 384 | E-7 | 414 | Pellet P117 | 414 |
| Ex. 118 | A-12 | 384 | E-8 | 415 | Pellet P118 | 415 |
| Ex. 119 | A-12 | 384 | E-9 | 415 | Pellet P119 | 415 |
| Ex. 120 | A-12 | 384 | E-10 | 416 | Pellet P120 | 416 |
| Ex. 121 | A-13 | 383 | E-1 | 415 | Pellet P121 | 415 |
| Ex. 122 | A-13 | 383 | E-2 | 415 | Pellet P122 | 415 |
| Ex. 123 | A-13 | 383 | E-3 | 414 | Pellet P123 | 414 |
| Ex. 124 | A-13 | 383 | E-4 | 416 | Pellet P124 | 416 |
| Ex. 125 | A-13 | 383 | E-5 | 419 | Pellet P125 | 419 |
| Ex. 126 | A-13 | 383 | E-6 | 413 | Pellet P126 | 413 |
| Ex. 127 | A-13 | 383 | E-7 | 414 | Pellet P127 | 414 |
| Ex. 128 | A-13 | 383 | E-8 | 415 | Pellet P128 | 415 |
| Ex. 129 | A-13 | 383 | E-9 | 415 | Pellet P129 | 415 |
| Ex. 130 | A-13 | 383 | E-10 | 416 | Pellet P130 | 416 |
| Ex. 131 | A-14 | 378 | E-1 | 415 | Pellet P131 | 415 |
| Ex. 132 | A-14 | 378 | E-2 | 415 | Pellet P132 | 415 |
| Ex. 133 | A-14 | 378 | E-3 | 414 | Pellet P133 | 414 |
| Ex. 134 | A-14 | 378 | E-4 | 416 | Pellet P134 | 416 |
| Ex. 135 | A-14 | 378 | E-5 | 419 | Pellet P135 | 419 |
| Ex. 136 | A-14 | 378 | E-6 | 413 | Pellet P136 | 413 |
| Ex. 137 | A-14 | 378 | E-7 | 414 | Pellet P137 | 414 |
| Ex. 138 | A-14 | 378 | E-8 | 415 | Pellet P138 | 415 |
| Ex. 139 | A-14 | 378 | E-9 | 415 | Pellet P139 | 415 |
| Ex. 140 | A-14 | 378 | E-10 | 416 | Pellet P140 | 416 |
| Ex. 141 | A-15 | 377 | E-1 | 415 | Pellet P141 | 415 |
| Ex. 142 | A-15 | 377 | E-2 | 415 | Pellet P142 | 415 |
| Ex. 143 | A-15 | 377 | E-3 | 414 | Pellet P143 | 414 |
| Ex. 144 | A-15 | 377 | E-4 | 416 | Pellet P144 | 416 |
| Ex. 145 | A-15 | 377 | E-5 | 419 | Pellet P145 | 419 |
| Ex. 146 | A-15 | 377 | E-6 | 413 | Pellet P146 | 413 |
| Ex. 147 | A-15 | 377 | E-7 | 414 | Pellet P147 | 414 |
| Ex. 148 | A-15 | 377 | E-8 | 415 | Pellet P148 | 415 |
| Ex. 149 | A-15 | 377 | E-9 | 415 | Pellet P149 | 415 |
| Ex. 150 | A-15 | 377 | E-10 | 416 | Pellet P150 | 416 |
| Ex. 151 | A-16 | 384 | E-1 | 415 | Pellet P151 | 415 |
| Ex. 152 | A-16 | 384 | E-2 | 415 | Pellet P152 | 415 |
| Ex. 153 | A-16 | 384 | E-3 | 414 | Pellet P153 | 414 |
| Ex. 154 | A-16 | 384 | E-4 | 416 | Pellet P154 | 416 |
| Ex. 155 | A-16 | 384 | E-5 | 419 | Pellet P155 | 419 |
| Ex. 156 | A-16 | 384 | E-6 | 413 | Pellet P156 | 413 |
| Ex. 157 | A-16 | 384 | E-7 | 414 | Pellet P157 | 414 |
| Ex. 158 | A-16 | 384 | E-8 | 415 | Pellet P158 | 415 |
| Ex. 159 | A-16 | 384 | E-9 | 415 | Pellet P159 | 415 |
| Ex. 160 | A-16 | 384 | E-10 | 416 | Pellet P160 | 416 |
| Ex. 161 | B-1 | 379 | E-1 | 415 | Pellet P161 | 415 |
| Ex. 162 | B-1 | 379 | E-2 | 415 | Pellet P162 | 415 |
| Ex. 163 | B-1 | 379 | E-3 | 414 | Pellet P163 | 414 |
| Ex. 164 | B-1 | 379 | E-4 | 416 | Pellet P164 | 416 |
| Ex. 165 | B-1 | 379 | E-5 | 419 | Pellet P165 | 419 |
| Ex. 166 | B-1 | 379 | E-6 | 413 | Pellet P166 | 413 |
| Ex. 167 | B-1 | 379 | E-7 | 414 | Pellet P167 | 414 |
| Ex. 168 | B-1 | 379 | E-8 | 415 | Pellet P168 | 415 |
| Ex. 169 | B-1 | 379 | E-9 | 415 | Pellet P169 | 415 |
| Ex. 170 | B-1 | 379 | E-10 | 416 | Pellet P170 | 416 |
| Ex. 171 | B-2 | 379 | E-1 | 415 | Pellet P171 | 415 |
| Ex. 172 | B-2 | 379 | E-2 | 415 | Pellet P172 | 415 |
| Ex. 173 | B-2 | 379 | E-3 | 414 | Pellet P173 | 414 |
| Ex. 174 | B-2 | 379 | E-4 | 416 | Pellet P174 | 416 |
| Ex. 175 | B-2 | 379 | E-5 | 419 | Pellet P175 | 419 |
| Ex. 176 | B-2 | 379 | E-6 | 413 | Pellet P176 | 413 |
| Ex. 177 | B-2 | 379 | E-7 | 414 | Pellet P177 | 414 |
| Ex. 178 | B-2 | 379 | E-8 | 415 | Pellet P178 | 415 |
| Ex. 179 | B-2 | 379 | E-9 | 415 | Pellet P179 | 415 |
| Ex. 180 | B-2 | 379 | E-10 | 416 | Pellet P180 | 416 |
| Ex. 181 | B-3 | 380 | E-1 | 415 | Pellet P181 | 415 |
| Ex. 182 | B-3 | 380 | E-2 | 415 | Pellet P182 | 415 |
| Ex. 183 | B-3 | 380 | E-3 | 414 | Pellet P183 | 414 |
| Ex. 184 | B-3 | 380 | E-4 | 416 | Pellet P184 | 416 |
| Ex. 185 | B-3 | 380 | E-5 | 419 | Pellet P185 | 419 |
| Ex. 186 | B-3 | 380 | E-6 | 413 | Pellet P186 | 413 |
| Ex. 187 | B-3 | 380 | E-7 | 414 | Pellet P187 | 414 |
| Ex. 188 | B-3 | 380 | E-8 | 415 | Pellet P188 | 415 |
| Ex. 189 | B-3 | 380 | E-9 | 415 | Pellet P189 | 415 |
| Ex. 190 | B-3 | 380 | E-10 | 416 | Pellet P190 | 416 |
| Ex. 191 | B-4 | 382 | E-1 | 415 | Pellet P191 | 415 |
| Ex. 192 | B-4 | 382 | E-2 | 415 | Pellet P192 | 415 |
| Ex. 193 | B-4 | 382 | E-3 | 414 | Pellet P193 | 414 |
| Ex. 194 | B-4 | 382 | E-4 | 416 | Pellet P194 | 416 |
| Ex. 195 | B-4 | 382 | E-5 | 419 | Pellet P195 | 419 |
| Ex. 196 | B-4 | 382 | E-6 | 413 | Pellet P196 | 413 |
| Ex. 197 | B-4 | 382 | E-7 | 414 | Pellet P197 | 414 |
| Ex. 198 | B-4 | 382 | E-8 | 415 | Pellet P198 | 415 |
| Ex. 199 | B-4 | 382 | E-9 | 415 | Pellet P199 | 415 |
| Ex. 200 | B-4 | 382 | E-10 | 416 | Pellet P200 | 416 |
| Ex. 201 | C-1 | 381 | E-1 | 415 | Pellet P201 | 415 |
| Ex. 202 | C-1 | 381 | E-2 | 415 | Pellet P202 | 415 |
| Ex. 203 | C-1 | 381 | E-3 | 414 | Pellet P203 | 414 |
| Ex. 204 | C-1 | 381 | E-4 | 416 | Pellet P204 | 416 |
| Ex. 205 | C-1 | 381 | E-5 | 419 | Pellet P205 | 419 |
| Ex. 206 | C-1 | 381 | E-6 | 413 | Pellet P206 | 413 |
| Ex. 207 | C-1 | 381 | E-7 | 414 | Pellet P207 | 414 |
| Ex. 208 | C-1 | 381 | E-8 | 415 | Pellet P208 | 415 |
| Ex. 209 | C-1 | 381 | E-9 | 415 | Pellet P209 | 415 |
| Ex. 210 | C-1 | 381 | E-10 | 416 | Pellet P210 | 416 |
| Ex. 211 | C-2 | 382 | E-1 | 415 | Pellet P211 | 415 |
| Ex. 212 | C-2 | 382 | E-2 | 415 | Pellet P212 | 415 |
| Ex. 213 | C-2 | 382 | E-3 | 414 | Pellet P213 | 414 |
| Ex. 214 | C-2 | 382 | E-4 | 416 | Pellet P214 | 416 |
| Ex. 215 | C-2 | 382 | E-5 | 419 | Pellet P215 | 419 |
| Ex. 216 | C-2 | 382 | E-6 | 413 | Pellet P216 | 413 |
| Ex. 217 | C-2 | 382 | E-7 | 414 | Pellet P217 | 414 |
| Ex. 218 | C-2 | 382 | E-8 | 415 | Pellet P218 | 415 |
| Ex. 219 | C-2 | 382 | E-9 | 415 | Pellet P219 | 415 |
| Ex. 220 | C-2 | 382 | E-10 | 416 | Pellet P220 | 416 |
| Ex. 221 | C-3 | 381 | E-1 | 415 | Pellet P221 | 415 |
| Ex. 222 | C-3 | 381 | E-2 | 415 | Pellet P222 | 415 |
| Ex. 223 | C-3 | 381 | E-3 | 414 | Pellet P223 | 414 |
| Ex. 224 | C-3 | 381 | E-4 | 416 | Pellet P224 | 416 |
| Ex. 225 | C-3 | 381 | E-5 | 419 | Pellet P225 | 419 |
| Ex. 226 | C-3 | 381 | E-6 | 413 | Pellet P226 | 413 |
| Ex. 227 | C-3 | 381 | E-7 | 414 | Pellet P227 | 414 |
| Ex. 228 | C-3 | 381 | E-8 | 415 | Pellet P228 | 415 |
| Ex. 229 | C-3 | 381 | E-9 | 415 | Pellet P229 | 415 |
| Ex. 230 | C-3 | 381 | E-10 | 416 | Pellet P230 | 416 |
| Ex. 231 | C-4 | 385 | E-1 | 415 | Pellet P231 | 415 |
| Ex. 232 | C-4 | 385 | E-2 | 415 | Pellet P232 | 415 |
| Ex. 233 | C-4 | 385 | E-3 | 414 | Pellet P233 | 414 |
| Ex. 234 | C-4 | 385 | E-4 | 416 | Pellet P234 | 416 |
| Ex. 235 | C-4 | 385 | E-5 | 419 | Pellet P235 | 419 |
| Ex. 236 | C-4 | 385 | E-6 | 413 | Pellet P236 | 413 |
| Ex. 237 | C-4 | 385 | E-7 | 414 | Pellet P237 | 414 |
| Ex. 238 | C-4 | 385 | E-8 | 415 | Pellet P238 | 415 |
| Ex. 239 | C-4 | 385 | E-9 | 415 | Pellet P239 | 415 |
| Ex. 240 | C-4 | 385 | E-10 | 416 | Pellet P240 | 416 |
| Ex. 241 | D-1 | 379 | E-1 | 415 | Pellet P241 | 415 |
| Ex. 242 | D-1 | 379 | E-2 | 415 | Pellet P242 | 415 |
| Ex. 243 | D-1 | 379 | E-3 | 414 | Pellet P243 | 414 |
| Ex. 244 | D-1 | 379 | E-4 | 416 | Pellet P244 | 416 |
| Ex. 245 | D-1 | 379 | E-5 | 419 | Pellet P245 | 419 |
| Ex. 246 | D-1 | 379 | E-6 | 413 | Pellet P246 | 413 |
| Ex. 247 | D-1 | 379 | E-7 | 414 | Pellet P247 | 414 |
| Ex. 248 | D-1 | 379 | E-8 | 415 | Pellet P248 | 415 |
| Ex. 249 | D-1 | 379 | E-9 | 415 | Pellet P249 | 415 |
| Ex. 250 | D-1 | 379 | E-10 | 416 | Pellet P250 | 416 |
| Ex. 251 | D-2 | 379 | E-1 | 415 | Pellet P251 | 415 |
| Ex. 252 | D-2 | 379 | E-2 | 415 | Pellet P252 | 415 |
| Ex. 253 | D-2 | 379 | E-3 | 414 | Pellet P253 | 414 |
| Ex. 254 | D-2 | 379 | E-4 | 416 | Pellet P254 | 416 |
| Ex. 255 | D-2 | 379 | E-5 | 419 | Pellet P255 | 419 |
| Ex. 256 | D-2 | 379 | E-6 | 413 | Pellet P256 | 413 |
| Ex. 257 | D-2 | 379 | E-7 | 414 | Pellet P257 | 414 |
| Ex. 258 | D-2 | 379 | E-8 | 415 | Pellet P258 | 415 |
| Ex. 259 | D-2 | 379 | E-9 | 415 | Pellet P259 | 415 |
| Ex. 260 | D-2 | 379 | E-10 | 416 | Pellet P260 | 416 |
| Ex. 261 | D-3 | 380 | E-1 | 415 | Pellet P261 | 415 |
| Ex. 262 | D-3 | 380 | E-2 | 415 | Pellet P262 | 415 |
| Ex. 263 | D-3 | 380 | E-3 | 414 | Pellet P263 | 414 |
| Ex. 264 | D-3 | 380 | E-4 | 416 | Pellet P264 | 416 |
| Ex. 265 | D-3 | 380 | E-5 | 419 | Pellet P265 | 419 |
| Ex. 266 | D-3 | 380 | E-6 | 413 | Pellet P266 | 413 |
| Ex. 267 | D-3 | 380 | E-7 | 414 | Pellet P267 | 414 |
| Ex. 268 | D-3 | 380 | E-8 | 415 | Pellet P268 | 415 |
| Ex. 269 | D-3 | 380 | E-9 | 415 | Pellet P269 | 415 |
| Ex. 270 | D-3 | 380 | E-10 | 416 | Pellet P270 | 416 |
| Ex. 271 | D-4 | 381 | E-1 | 415 | Pellet P271 | 415 |
| Ex. 272 | D-4 | 381 | E-2 | 415 | Pellet P272 | 415 |
| Ex. 273 | D-4 | 381 | E-3 | 414 | Pellet P273 | 414 |
| Ex. 274 | D-4 | 381 | E-4 | 416 | Pellet P274 | 416 |
| Ex. 275 | D-4 | 381 | E-5 | 419 | Pellet P275 | 419 |
| Ex. 276 | D-4 | 381 | E-6 | 413 | Pellet P276 | 413 |
| Ex. 277 | D-4 | 381 | E-7 | 414 | Pellet P277 | 414 |
| Ex. 278 | D-4 | 381 | E-8 | 415 | Pellet P278 | 415 |
| Ex. 279 | D-4 | 381 | E-9 | 415 | Pellet P279 | 415 |
| Ex. 280 | D-4 | 381 | E-10 | 416 | Pellet P280 | 416 |
| C. Ex. 1 | A-1 | 380 | E-1 | 415 | Simple mixture comA | 415 |

As shown in Table 1, it was confirmed that pellets P1 to P280 (Examples 1 to 280) according to the present invention had the same maximum emission wavelength as the relatively longer wavelength compound compared to each raw material compound (compounds A-1 to D-4 and compounds E-1 to E-10).

### [EXPERIMENTAL EXAMPLE 2] - Performance Evaluation of Organic EL Devices

The green organic EL devices fabricated in Examples 1 to 280 and Comparative Example 1 were measured for driving voltage, current efficiency, and lifetime T97 at a current density of 10 mA/cm². The results are summarized in Table 2.

**TABLE 2**

| Sample | Material of Pellet | | Host | Drivin g Volt. V) | EL Peak (nm) | Current Effici. (cd/A) | Lifespan (hr, T₉₇) |
|---|---|---|---|---|---|---|---|
| | 1^{st} Organic Cpd. | 2^{nd} Organic Cpd. | | | | | |
| Ex. 1 | A-1 | E-1 | Pellet P1 | 3.45 | 515 | 141.4 | 401 |
| Ex. 2 | A-1 | E-2 | Pellet P2 | 3.84 | 516 | 144.2 | 402 |
| Ex. 3 | A-1 | E-3 | Pellet P3 | 3.45 | 518 | 146.1 | 392 |
| Ex. 4 | A-1 | E-4 | Pellet P4 | 3.54 | 518 | 144.3 | 399 |
| Ex. 5 | A-1 | E-5 | Pellet P5 | 3.65 | 518 | 145.1 | 391 |
| Ex. 6 | A-1 | E-6 | Pellet P6 | 3.45 | 517 | 145.4 | 403 |
| Ex. 7 | A-1 | E-7 | Pellet P7 | 3.56 | 515 | 144.2 | 412 |
| Ex. 8 | A-1 | E-8 | Pellet P8 | 3.67 | 518 | 146.1 | 421 |
| Ex. 9 | A-1 | E-9 | Pellet P9 | 3.54 | 518 | 144.3 | 391 |
| Ex. 10 | A-1 | E-10 | Pellet P10 | 3.56 | 517 | 145.1 | 404 |
| Ex. 11 | A-2 | E-1 | Pellet P11 | 3.45 | 515 | 141.4 | 401 |
| Ex. 12 | A-2 | E-2 | Pellet P12 | 3.52 | 516 | 144.3 | 370 |
| Ex. 13 | A-2 | E-3 | Pellet P13 | 3.54 | 518 | 144.3 | 399 |
| Ex. 14 | A-2 | E-4 | Pellet P14 | 3.65 | 518 | 145.1 | 391 |
| Ex. 15 | A-2 | E-5 | Pellet P15 | 3.45 | 517 | 145.4 | 403 |
| Ex. 16 | A-2 | E-6 | Pellet P16 | 3.56 | 515 | 144.2 | 412 |
| Ex. 17 | A-2 | E-7 | Pellet P17 | 3.67 | 518 | 146.1 | 421 |
| Ex. 18 | A-2 | E-8 | Pellet P18 | 3.54 | 518 | 144.3 | 391 |
| Ex. 19 | A-2 | E-9 | Pellet P19 | 3.45 | 517 | 145.4 | 403 |
| Ex. 20 | A-2 | E-10 | Pellet P20 | 3.56 | 515 | 144.2 | 412 |
| Ex. 21 | A-3 | E-1 | Pellet P21 | 3.67 | 518 | 146.1 | 421 |
| Ex. 22 | A-3 | E-2 | Pellet P22 | 3.81 | 516 | 142.3 | 380 |
| Ex. 23 | A-3 | E-3 | Pellet P23 | 3.54 | 515 | 144.2 | 391 |
| Ex. 24 | A-3 | E-4 | Pellet P24 | 3.65 | 518 | 146.1 | 403 |
| Ex. 25 | A-3 | E-5 | Pellet P25 | 3.55 | 518 | 144.3 | 412 |
| Ex. 26 | A-3 | E-6 | Pellet P26 | 3.65 | 518 | 141.4 | 391 |
| Ex. 27 | A-3 | E-7 | Pellet P27 | 3.48 | 517 | 145.4 | 403 |
| Ex. 28 | A-3 | E-8 | Pellet P28 | 3.56 | 517 | 144.2 | 412 |
| Ex. 29 | A-3 | E-9 | Pellet P29 | 3.84 | 515 | 146.1 | 421 |
| Ex. 30 | A-3 | E-10 | Pellet P30 | 3.45 | 518 | 144.3 | 391 |
| Ex. 31 | A-4 | E-1 | Pellet P31 | 3.48 | 517 | 144.2 | 391 |
| Ex. 32 | A-4 | E-2 | Pellet P32 | 3.67 | 517 | 142.3 | 391 |
| Ex. 33 | A-4 | E-3 | Pellet P33 | 3.54 | 515 | 144.3 | 404 |
| Ex. 34 | A-4 | E-4 | Pellet P34 | 3.45 | 518 | 142.3 | 374 |
| Ex. 35 | A-4 | E-5 | Pellet P35 | 3.54 | 518 | 145.4 | 390 |
| Ex. 36 | A-4 | E-6 | Pellet P36 | 3.65 | 518 | 146.1 | 403 |
| Ex. 37 | A-4 | E-7 | Pellet P37 | 3.48 | 518 | 141.4 | 401 |
| Ex. 38 | A-4 | E-8 | Pellet P38 | 3.81 | 516 | 142.3 | 380 |
| Ex. 39 | A-4 | E-9 | Pellet P39 | 3.54 | 515 | 144.2 | 391 |
| Ex. 40 | A-4 | E-10 | Pellet P40 | 3.65 | 518 | 146.1 | 403 |
| Ex. 41 | A-5 | E-1 | Pellet P41 | 3.55 | 518 | 144.3 | 412 |
| Ex. 42 | A-5 | E-2 | Pellet P42 | 3.65 | 518 | 141.4 | 391 |
| Ex. 43 | A-5 | E-3 | Pellet P43 | 3.48 | 517 | 145.4 | 403 |
| Ex. 44 | A-5 | E-4 | Pellet P44 | 3.56 | 517 | 144.2 | 412 |
| Ex. 45 | A-5 | E-5 | Pellet P45 | 3.45 | 517 | 145.4 | 403 |
| Ex. 46 | A-5 | E-6 | Pellet P46 | 3.56 | 515 | 144.2 | 412 |
| Ex. 47 | A-5 | E-7 | Pellet P47 | 3.67 | 518 | 146.1 | 421 |
| Ex. 48 | A-5 | E-8 | Pellet P48 | 3.81 | 516 | 142.3 | 380 |
| Ex. 49 | A-5 | E-9 | Pellet P49 | 3.54 | 515 | 144.2 | 391 |
| Ex. 50 | A-5 | E-10 | Pellet P50 | 3.65 | 518 | 146.1 | 403 |
| Ex. 51 | A-6 | E-1 | Pellet P51 | 3.55 | 518 | 144.3 | 412 |
| Ex. 52 | A-6 | E-2 | Pellet P52 | 3.65 | 518 | 141.4 | 391 |
| Ex. 53 | A-6 | E-3 | Pellet P53 | 3.48 | 517 | 145.4 | 403 |
| Ex. 54 | A-6 | E-4 | Pellet P54 | 3.56 | 517 | 144.2 | 412 |
| Ex. 55 | A-6 | E-5 | Pellet P55 | 3.84 | 515 | 146.1 | 421 |
| Ex. 56 | A-6 | E-6 | Pellet P56 | 3.45 | 518 | 144.3 | 391 |
| Ex. 57 | A-6 | E-7 | Pellet P57 | 3.48 | 517 | 144.2 | 391 |
| Ex. 58 | A-6 | E-8 | Pellet P58 | 3.67 | 517 | 142.3 | 391 |
| Ex. 59 | A-6 | E-9 | Pellet P59 | 3.54 | 515 | 144.3 | 404 |
| Ex. 60 | A-6 | E-10 | Pellet P60 | 3.45 | 518 | 142.3 | 374 |
| Ex. 61 | A-7 | E-1 | Pellet P61 | 3.48 | 517 | 144.2 | 391 |
| Ex. 62 | A-7 | E-2 | Pellet P62 | 3.65 | 518 | 142.4 | 411 |
| Ex. 63 | A-7 | E-3 | Pellet P63 | 3.55 | 515 | 144.3 | 404 |
| Ex. 64 | A-7 | E-4 | Pellet P64 | 3.81 | 518 | 142.3 | 374 |
| Ex. 65 | A-7 | E-5 | Pellet P65 | 3.56 | 518 | 145.4 | 390 |
| Ex. 66 | A-7 | E-6 | Pellet P66 | 3.58 | 518 | 146.1 | 403 |
| Ex. 67 | A-7 | E-7 | Pellet P67 | 3.89 | 517 | 144.3 | 412 |
| Ex. 68 | A-7 | E-8 | Pellet P68 | 3.65 | 518 | 141.4 | 391 |
| Ex. 69 | A-7 | E-9 | Pellet P69 | 3.48 | 517 | 145.4 | 403 |
| Ex. 70 | A-7 | E-10 | Pellet P70 | 3.56 | 517 | 144.2 | 412 |
| Ex. 71 | A-8 | E-1 | Pellet P71 | 3.84 | 515 | 146.1 | 421 |
| Ex. 72 | A-8 | E-2 | Pellet P72 | 3.45 | 518 | 144.3 | 391 |
| Ex. 73 | A-8 | E-3 | Pellet P73 | 3.48 | 517 | 144.2 | 391 |
| Ex. 74 | A-8 | E-4 | Pellet P74 | 3.56 | 516 | 144.3 | 404 |
| Ex. 75 | A-8 | E-5 | Pellet P75 | 3.48 | 516 | 142.3 | 401 |
| Ex. 76 | A-8 | E-6 | Pellet P76 | 3.81 | 518 | 142.4 | 411 |
| Ex. 77 | A-8 | E-7 | Pellet P77 | 3.54 | 516 | 144.2 | 412 |
| Ex. 78 | A-8 | E-8 | Pellet P78 | 3.65 | 515 | 146.1 | 421 |
| Ex. 79 | A-8 | E-9 | Pellet P79 | 3.65 | 518 | 141.4 | 391 |
| Ex. 80 | A-8 | E-10 | Pellet P80 | 3.54 | 517 | 143.1 | 403 |
| Ex. 81 | A-9 | E-1 | Pellet P81 | 3.56 | 515 | 146.5 | 412 |
| Ex. 82 | A-9 | E-2 | Pellet P82 | 3.45 | 516 | 141.8 | 421 |
| Ex. 83 | A-9 | E-3 | Pellet P83 | 3.52 | 515 | 140.7 | 412 |
| Ex. 84 | A-9 | E-4 | Pellet P84 | 3.74 | 516 | 144.3 | 421 |
| Ex. 85 | A-9 | E-5 | Pellet P85 | 3.52 | 516 | 141.8 | 391 |
| Ex. 86 | A-9 | E-6 | Pellet P86 | 3.74 | 515 | 140.7 | 404 |
| Ex. 87 | A-9 | E-7 | Pellet P87 | 3.84 | 518 | 144.1 | 401 |
| Ex. 88 | A-9 | E-8 | Pellet P88 | 3.45 | 518 | 144.3 | 370 |
| Ex. 89 | A-9 | E-9 | Pellet P89 | 3.54 | 518 | 142.3 | 399 |
| Ex. 90 | A-9 | E-10 | Pellet P90 | 3.65 | 517 | 144.3 | 391 |
| Ex. 91 | A-10 | E-1 | Pellet P91 | 3.55 | 517 | 145.1 | 403 |
| Ex. 92 | A-10 | E-2 | Pellet P92 | 3.67 | 518 | 144.2 | 412 |
| Ex. 93 | A-10 | E-3 | Pellet P93 | 3.54 | 517 | 143.1 | 421 |
| Ex. 94 | A-10 | E-4 | Pellet P94 | 3.56 | 515 | 146.5 | 412 |
| Ex. 95 | A-10 | E-5 | Pellet P95 | 3.45 | 516 | 141.8 | 421 |
| Ex. 96 | A-10 | E-6 | Pellet P96 | 3.52 | 515 | 140.7 | 391 |
| Ex. 97 | A-10 | E-7 | Pellet P97 | 3.74 | 516 | 144.3 | 404 |
| Ex. 98 | A-10 | E-8 | Pellet P98 | 3.54 | 516 | 142.3 | 401 |
| Ex. 99 | A-10 | E-9 | Pellet P99 | 3.65 | 518 | 142.4 | 411 |
| Ex. 100 | A-10 | E-10 | Pellet P100 | 3.54 | 518 | 144.3 | 399 |
| Ex. 101 | A-11 | E-1 | Pellet P101 | 3.65 | 518 | 145.1 | 391 |
| Ex. 102 | A-11 | E-2 | Pellet P102 | 3.55 | 517 | 145.4 | 403 |
| Ex. 103 | A-11 | E-3 | Pellet P103 | 3.67 | 515 | 144.2 | 412 |
| Ex. 104 | A-11 | E-4 | Pellet P104 | 3.54 | 518 | 146.1 | 421 |
| Ex. 105 | A-11 | E-5 | Pellet P105 | 3.56 | 518 | 144.3 | 391 |
| Ex. 106 | A-11 | E-6 | Pellet P106 | 3.45 | 517 | 145.1 | 404 |
| Ex. 107 | A-11 | E-7 | Pellet P107 | 3.54 | 515 | 141.4 | 401 |
| Ex. 108 | A-11 | E-8 | Pellet P108 | 3.52 | 516 | 144.3 | 370 |
| Ex. 109 | A-11 | E-9 | Pellet P109 | 3.54 | 518 | 144.3 | 399 |
| Ex. 110 | A-11 | E-10 | Pellet P110 | 3.65 | 518 | 145.1 | 391 |
| Ex. 111 | A-12 | E-1 | Pellet P111 | 3.45 | 517 | 145.4 | 403 |
| Ex. 112 | A-12 | E-2 | Pellet P112 | 3.56 | 515 | 144.2 | 412 |
| Ex. 113 | A-12 | E-3 | Pellet P113 | 3.67 | 518 | 146.1 | 421 |
| Ex. 114 | A-12 | E-4 | Pellet P114 | 3.54 | 518 | 144.3 | 391 |
| Ex. 115 | A-12 | E-5 | Pellet P115 | 3.45 | 517 | 145.4 | 403 |
| Ex. 116 | A-12 | E-6 | Pellet P116 | 3.56 | 515 | 144.2 | 412 |
| Ex. 117 | A-12 | E-7 | Pellet P117 | 3.67 | 518 | 146.1 | 421 |
| Ex. 118 | A-12 | E-8 | Pellet P118 | 3.81 | 518 | 142.3 | 380 |
| Ex. 119 | A-12 | E-9 | Pellet P119 | 3.54 | 517 | 144.2 | 391 |
| Ex. 120 | A-12 | E-10 | Pellet P120 | 3.65 | 515 | 146.1 | 403 |
| Ex. 121 | A-13 | E-1 | Pellet P121 | 3.55 | 516 | 144.3 | 412 |
| Ex. 122 | A-13 | E-2 | Pellet P122 | 3.65 | 516 | 141.4 | 391 |
| Ex. 123 | A-13 | E-3 | Pellet P123 | 3.55 | 515 | 141.8 | 412 |
| Ex. 124 | A-13 | E-4 | Pellet P124 | 3.67 | 518 | 140.7 | 421 |
| Ex. 125 | A-13 | E-5 | Pellet P125 | 3.54 | 518 | 144.1 | 391 |
| Ex. 126 | A-13 | E-6 | Pellet P126 | 3.56 | 518 | 144.3 | 404 |
| Ex. 127 | A-13 | E-7 | Pellet P127 | 3.45 | 518 | 142.3 | 374 |
| Ex. 128 | A-13 | E-8 | Pellet P128 | 3.54 | 517 | 145.4 | 390 |
| Ex. 129 | A-13 | E-9 | Pellet P129 | 3.56 | 515 | 144.2 | 391 |
| Ex. 130 | A-13 | E-10 | Pellet P130 | 3.45 | 518 | 146.1 | 403 |
| Ex. 131 | A-14 | E-1 | Pellet P131 | 3.56 | 518 | 144.3 | 412 |
| Ex. 132 | A-14 | E-2 | Pellet P132 | 3.48 | 517 | 145.1 | 391 |
| Ex. 133 | A-14 | E-3 | Pellet P133 | 3.48 | 515 | 141.4 | 403 |
| Ex. 134 | A-14 | E-4 | Pellet P134 | 3.81 | 516 | 144.3 | 412 |
| Ex. 135 | A-14 | E-5 | Pellet P135 | 3.65 | 518 | 145.1 | 391 |
| Ex. 136 | A-14 | E-6 | Pellet P136 | 3.45 | 517 | 145.4 | 403 |
| Ex. 137 | A-14 | E-7 | Pellet P137 | 3.56 | 515 | 144.2 | 412 |
| Ex. 138 | A-14 | E-8 | Pellet P138 | 3.67 | 518 | 146.1 | 421 |
| Ex. 139 | A-14 | E-9 | Pellet P139 | 3.54 | 518 | 144.3 | 391 |
| Ex. 140 | A-14 | E-10 | Pellet P140 | 3.45 | 517 | 145.4 | 403 |
| Ex. 141 | A-15 | E-1 | Pellet P141 | 3.56 | 515 | 144.2 | 412 |
| Ex. 142 | A-15 | E-2 | Pellet P142 | 3.67 | 518 | 146.1 | 421 |
| Ex. 143 | A-15 | E-3 | Pellet P143 | 3.54 | 518 | 145.4 | 390 |
| Ex. 144 | A-15 | E-4 | Pellet P144 | 3.56 | 518 | 144.2 | 391 |
| Ex. 145 | A-15 | E-5 | Pellet P145 | 3.45 | 518 | 146.1 | 403 |
| Ex. 146 | A-15 | E-6 | Pellet P146 | 3.56 | 518 | 144.3 | 412 |
| Ex. 147 | A-15 | E-7 | Pellet P147 | 3.48 | 517 | 145.1 | 391 |
| Ex. 148 | A-15 | E-8 | Pellet P148 | 3.48 | 515 | 141.4 | 403 |
| Ex. 149 | A-15 | E-9 | Pellet P149 | 3.81 | 516 | 144.3 | 412 |
| Ex. 150 | A-15 | E-10 | Pellet P150 | 3.54 | 516 | 142.3 | 421 |
| Ex. 151 | A-16 | E-1 | Pellet P151 | 3.65 | 518 | 142.3 | 391 |
| Ex. 152 | A-16 | E-2 | Pellet P152 | 3.56 | 518 | 144.3 | 404 |
| Ex. 153 | A-16 | E-3 | Pellet P153 | 3.45 | 518 | 142.3 | 374 |
| Ex. 154 | A-16 | E-4 | Pellet P154 | 3.54 | 517 | 145.4 | 390 |
| Ex. 155 | A-16 | E-5 | Pellet P155 | 3.56 | 515 | 144.2 | 391 |
| Ex. 156 | A-16 | E-6 | Pellet P156 | 3.45 | 518 | 146.1 | 403 |
| Ex. 157 | A-16 | E-7 | Pellet P157 | 3.56 | 518 | 144.3 | 412 |
| Ex. 158 | A-16 | E-8 | Pellet P158 | 3.48 | 517 | 145.1 | 391 |
| Ex. 159 | A-16 | E-9 | Pellet P159 | 3.48 | 515 | 141.4 | 403 |
| Ex. 160 | A-16 | E-10 | Pellet P160 | 3.81 | 516 | 144.3 | 412 |
| Ex. 161 | B-1 | E-1 | Pellet P161 | 3.55 | 516 | 141.8 | 412 |
| Ex. 162 | B-1 | E-2 | Pellet P162 | 3.67 | 515 | 140.7 | 421 |
| Ex. 163 | B-1 | E-3 | Pellet P163 | 3.54 | 518 | 145.4 | 391 |
| Ex. 164 | B-1 | E-4 | Pellet P164 | 3.56 | 518 | 144.2 | 404 |
| Ex. 165 | B-1 | E-5 | Pellet P165 | 3.45 | 518 | 146.1 | 374 |
| Ex. 166 | B-1 | E-6 | Pellet P166 | 3.54 | 517 | 144.3 | 390 |
| Ex. 167 | B-1 | E-7 | Pellet P167 | 3.56 | 515 | 145.1 | 391 |
| Ex. 168 | B-1 | E-8 | Pellet P168 | 3.45 | 518 | 141.4 | 391 |
| Ex. 169 | B-1 | E-9 | Pellet P169 | 3.56 | 518 | 144.3 | 403 |
| Ex. 170 | B-1 | E-10 | Pellet P170 | 3.48 | 517 | 142.3 | 412 |
| Ex. 171 | B-2 | E-1 | Pellet P171 | 3.48 | 515 | 141.4 | 404 |
| Ex. 172 | B-2 | E-2 | Pellet P172 | 3.81 | 516 | 144.3 | 374 |
| Ex. 173 | B-2 | E-3 | Pellet P173 | 3.54 | 516 | 142.3 | 390 |
| Ex. 174 | B-2 | E-4 | Pellet P174 | 3.65 | 518 | 146.1 | 401 |
| Ex. 175 | B-2 | E-5 | Pellet P175 | 3.81 | 516 | 144.3 | 411 |
| Ex. 176 | B-2 | E-6 | Pellet P176 | 3.54 | 516 | 142.3 | 412 |
| Ex. 177 | B-2 | E-7 | Pellet P177 | 3.65 | 518 | 142.3 | 391 |
| Ex. 178 | B-2 | E-8 | Pellet P178 | 3.56 | 518 | 144.3 | 404 |
| Ex. 179 | B-2 | E-9 | Pellet P179 | 3.45 | 518 | 142.3 | 374 |
| Ex. 180 | B-2 | E-10 | Pellet P180 | 3.54 | 517 | 145.4 | 390 |
| Ex. 181 | B-3 | E-1 | Pellet P181 | 3.56 | 515 | 144.2 | 391 |
| Ex. 182 | B-3 | E-2 | Pellet P182 | 3.52 | 516 | 141.8 | 370 |
| Ex. 183 | B-3 | E-3 | Pellet P183 | 3.74 | 515 | 140.7 | 380 |
| Ex. 184 | B-3 | E-4 | Pellet P184 | 3.84 | 518 | 144.1 | 385 |
| Ex. 185 | B-3 | E-5 | Pellet P185 | 3.45 | 518 | 144.3 | 404 |
| Ex. 186 | B-3 | E-6 | Pellet P186 | 3.54 | 518 | 142.3 | 374 |
| Ex. 187 | B-3 | E-7 | Pellet P187 | 3.65 | 517 | 144.3 | 390 |
| Ex. 188 | B-3 | E-8 | Pellet P188 | 3.55 | 517 | 145.1 | 421 |
| Ex. 189 | B-3 | E-9 | Pellet P189 | 3.67 | 518 | 144.2 | 391 |
| Ex. 190 | B-3 | E-10 | Pellet P190 | 3.54 | 517 | 143.1 | 403 |
| Ex. 191 | B-4 | E-1 | Pellet P191 | 3.56 | 515 | 146.5 | 412 |
| Ex. 192 | B-4 | E-2 | Pellet P192 | 3.45 | 516 | 141.8 | 421 |
| Ex. 193 | B-4 | E-3 | Pellet P193 | 3.52 | 515 | 140.7 | 391 |
| Ex. 194 | B-4 | E-4 | Pellet P194 | 3.74 | 516 | 144.3 | 404 |
| Ex. 195 | B-4 | E-5 | Pellet P195 | 3.54 | 516 | 142.3 | 401 |
| Ex. 196 | B-4 | E-6 | Pellet P196 | 3.65 | 518 | 142.4 | 411 |
| Ex. 197 | B-4 | E-7 | Pellet P197 | 3.55 | 516 | 144.2 | 412 |
| Ex. 198 | B-4 | E-8 | Pellet P198 | 3.67 | 515 | 146.1 | 421 |
| Ex. 199 | B-4 | E-9 | Pellet P199 | 3.54 | 518 | 144.3 | 391 |
| Ex. 200 | B-4 | E-10 | Pellet P200 | 3.56 | 516 | 141.2 | 390 |
| Ex. 201 | C-1 | E-1 | Pellet P201 | 3.45 | 518 | 142.3 | 374 |
| Ex. 202 | C-1 | E-2 | Pellet P202 | 3.54 | 517 | 145.4 | 404 |
| Ex. 203 | C-1 | E-3 | Pellet P203 | 3.56 | 515 | 144.2 | 374 |
| Ex. 204 | C-1 | E-4 | Pellet P204 | 3.45 | 518 | 146.1 | 390 |
| Ex. 205 | C-1 | E-5 | Pellet P205 | 3.56 | 518 | 144.3 | 412 |
| Ex. 206 | C-1 | E-6 | Pellet P206 | 3.48 | 517 | 145.1 | 391 |
| Ex. 207 | C-1 | E-7 | Pellet P207 | 3.48 | 515 | 141.4 | 403 |
| Ex. 208 | C-1 | E-8 | Pellet P208 | 3.54 | 518 | 142.3 | 391 |
| Ex. 209 | C-1 | E-9 | Pellet P209 | 3.65 | 517 | 144.3 | 412 |
| Ex. 210 | C-1 | E-10 | Pellet P210 | 3.55 | 517 | 145.1 | 421 |
| Ex. 211 | C-2 | E-1 | Pellet P211 | 3.67 | 518 | 144.2 | 391 |
| Ex. 212 | C-2 | E-2 | Pellet P212 | 3.54 | 517 | 143.1 | 404 |
| Ex. 213 | C-2 | E-3 | Pellet P213 | 3.56 | 515 | 146.5 | 401 |
| Ex. 214 | C-2 | E-4 | Pellet P214 | 3.45 | 516 | 141.8 | 411 |
| Ex. 215 | C-2 | E-5 | Pellet P215 | 3.52 | 515 | 140.7 | 374 |
| Ex. 216 | C-2 | E-6 | Pellet P216 | 3.74 | 516 | 144.3 | 390 |
| Ex. 217 | C-2 | E-7 | Pellet P217 | 3.54 | 516 | 142.3 | 374 |
| Ex. 218 | C-2 | E-8 | Pellet P218 | 3.65 | 518 | 142.4 | 390 |
| Ex. 219 | C-2 | E-9 | Pellet P219 | 3.81 | 516 | 144.3 | 391 |
| Ex. 220 | C-2 | E-10 | Pellet P220 | 3.55 | 516 | 141.8 | 403 |
| Ex. 221 | C-3 | E-1 | Pellet P221 | 3.67 | 515 | 140.7 | 412 |
| Ex. 222 | C-3 | E-2 | Pellet P222 | 3.54 | 518 | 144.1 | 391 |
| Ex. 223 | C-3 | E-3 | Pellet P223 | 3.56 | 518 | 144.3 | 404 |
| Ex. 224 | C-3 | E-4 | Pellet P224 | 3.45 | 518 | 142.3 | 374 |
| Ex. 225 | C-3 | E-5 | Pellet P225 | 3.54 | 517 | 145.4 | 390 |
| Ex. 226 | C-3 | E-6 | Pellet P226 | 3.56 | 515 | 144.2 | 391 |
| Ex. 227 | C-3 | E-7 | Pellet P227 | 3.45 | 518 | 146.1 | 403 |
| Ex. 228 | C-3 | E-8 | Pellet P228 | 3.56 | 518 | 144.3 | 412 |
| Ex. 229 | C-3 | E-9 | Pellet P229 | 3.48 | 517 | 145.1 | 391 |
| Ex. 230 | C-3 | E-10 | Pellet P230 | 3.48 | 515 | 141.4 | 403 |
| Ex. 231 | C-4 | E-1 | Pellet P231 | 3.81 | 516 | 144.3 | 412 |
| Ex. 232 | C-4 | E-2 | Pellet P232 | 3.54 | 516 | 142.3 | 421 |
| Ex. 233 | C-4 | E-3 | Pellet P233 | 3.65 | 518 | 142.3 | 391 |
| Ex. 234 | C-4 | E-4 | Pellet P234 | 3.55 | 517 | 145.4 | 404 |
| Ex. 235 | C-4 | E-5 | Pellet P235 | 3.67 | 515 | 144.2 | 401 |
| Ex. 236 | C-4 | E-6 | Pellet P236 | 3.54 | 518 | 146.1 | 411 |
| Ex. 237 | C-4 | E-7 | Pellet P237 | 3.45 | 518 | 144.3 | 374 |
| Ex. 238 | C-4 | E-8 | Pellet P238 | 3.54 | 517 | 145.1 | 390 |
| Ex. 239 | C-4 | E-9 | Pellet P239 | 3.45 | 518 | 142.3 | 374 |
| Ex. 240 | C-4 | E-10 | Pellet P240 | 3.54 | 517 | 145.4 | 390 |
| Ex. 241 | D-1 | E-1 | Pellet P241 | 3.56 | 515 | 144.2 | 391 |
| Ex. 242 | D-1 | E-2 | Pellet P242 | 3.45 | 518 | 146.1 | 403 |
| Ex. 243 | D-1 | E-3 | Pellet P243 | 3.56 | 518 | 144.3 | 412 |
| Ex. 244 | D-1 | E-4 | Pellet P244 | 3.48 | 517 | 145.1 | 391 |
| Ex. 245 | D-1 | E-5 | Pellet P245 | 3.48 | 515 | 141.4 | 403 |
| Ex. 246 | D-1 | E-6 | Pellet P246 | 3.81 | 516 | 144.3 | 412 |
| Ex. 247 | D-1 | E-7 | Pellet P247 | 3.54 | 516 | 142.3 | 421 |
| Ex. 248 | D-1 | E-8 | Pellet P248 | 3.65 | 518 | 142.3 | 391 |
| Ex. 249 | D-1 | E-9 | Pellet P249 | 3.45 | 518 | 142.3 | 374 |
| Ex. 250 | D-1 | E-10 | Pellet P250 | 3.54 | 517 | 145.4 | 390 |
| Ex. 251 | D-2 | E-1 | Pellet P251 | 3.56 | 515 | 144.2 | 391 |
| Ex. 252 | D-2 | E-2 | Pellet P252 | 3.45 | 518 | 146.1 | 403 |
| Ex. 253 | D-2 | E-3 | Pellet P253 | 3.56 | 518 | 144.3 | 412 |
| Ex. 254 | D-2 | E-4 | Pellet P254 | 3.48 | 517 | 145.1 | 391 |
| Ex. 255 | D-2 | E-5 | Pellet P255 | 3.48 | 515 | 141.4 | 403 |
| Ex. 256 | D-2 | E-6 | Pellet P256 | 3.81 | 516 | 144.3 | 412 |
| Ex. 257 | D-2 | E-7 | Pellet P257 | 3.54 | 516 | 142.3 | 421 |
| Ex. 258 | D-2 | E-8 | Pellet P258 | 3.65 | 518 | 142.3 | 391 |
| Ex. 259 | D-2 | E-9 | Pellet P259 | 3.55 | 517 | 145.4 | 404 |
| Ex. 260 | D-2 | E-10 | Pellet P260 | 3.67 | 515 | 144.2 | 401 |
| Ex. 261 | D-3 | E-1 | Pellet P261 | 3.54 | 518 | 142.3 | 411 |
| Ex. 262 | D-3 | E-2 | Pellet P262 | 3.45 | 518 | 142.3 | 374 |
| Ex. 263 | D-3 | E-3 | Pellet P263 | 3.54 | 517 | 145.4 | 390 |
| Ex. 264 | D-3 | E-4 | Pellet P264 | 3.56 | 515 | 144.2 | 391 |
| Ex. 265 | D-3 | E-5 | Pellet P265 | 3.45 | 518 | 146.1 | 403 |
| Ex. 266 | D-3 | E-6 | Pellet P266 | 3.56 | 517 | 144.3 | 412 |
| Ex. 267 | D-3 | E-7 | Pellet P267 | 3.48 | 515 | 145.1 | 391 |
| Ex. 268 | D-3 | E-8 | Pellet P268 | 3.48 | 518 | 145.1 | 403 |
| Ex. 269 | D-3 | E-9 | Pellet P269 | 3.81 | 518 | 141.4 | 412 |
| Ex. 270 | D-3 | E-10 | Pellet P270 | 3.56 | 517 | 144.3 | 421 |
| Ex. 271 | D-4 | E-1 | Pellet P271 | 3.45 | 517 | 142.3 | 411 |
| Ex. 272 | D-4 | E-2 | Pellet P272 | 3.56 | 515 | 145.4 | 374 |
| Ex. 273 | D-4 | E-3 | Pellet P273 | 3.48 | 515 | 144.2 | 390 |
| Ex. 274 | D-4 | E-4 | Pellet P274 | 3.48 | 518 | 146.1 | 412 |
| Ex. 275 | D-4 | E-5 | Pellet P275 | 3.81 | 518 | 144.3 | 391 |
| Ex. 276 | D-4 | E-6 | Pellet P276 | 3.54 | 517 | 145.1 | 403 |
| Ex. 277 | D-4 | E-7 | Pellet P277 | 3.48 | 517 | 145.1 | 412 |
| Ex. 278 | D-4 | E-8 | Pellet P278 | 3.48 | 515 | 141.4 | 421 |
| Ex. 279 | D-4 | E-9 | Pellet P279 | 3.81 | 516 | 144.3 | 411 |
| Ex. 280 | D-4 | E-10 | Pellet P280 | 3.56 | 516 | 142.3 | 374 |
| C. Ex. 1 | A-1 | E-1 | Simple mixture comA | 4.31 | 515 | 121.4 | 150 |

As shown in Table 2, the green organic EL device of Example 1, using Pellet P1 as the host material for the emission layer, exhibited a lower driving voltage, higher current efficiency, and longer lifespan compared to the green organic EL device of Comparative Example 1, which used the simple mixture comA. This indicates that the use of the pellet according to the present invention as a material for the organic layer (e.g., the host material for the emission layer) in OLEDs can improve the performance of the organic EL device.

### [EXPERIMENTAL EXAMPLE 3]

In Examples 1, 281 to 282, and Comparative Examples 1 to 3, when green organic EL devices were fabricated, thin films were formed through a continuous process. The weight ratio changes of compounds A-1 and E-1 in pellets P1, P281 to P282, and simple mixtures comA to comC before and after the process were measured. The results are summarized in Table 3.

**TABLE 3**

| Sample | Pre-Process | | Post-Process | | Temporal change (%) |
|---|---|---|---|---|---|
| | Cpd. A-1 (Wt. ratio) | Cpd. E-1 (Wt. ratio) | Cpd. A-1 (Wt. ratio) | Cpd. E-1 (Wt. ratio) | |
| Ex. 1 (Pellet P1) | 60 | 40 | 59.8 | 40.2 | 0.2 |
| Ex. 281 (Pellet P281) | 50 | 50 | 50.1 | 49.9 | 0.1 |
| Ex. 282 (Pellet P282) | 70 | 30 | 70.1 | 29.9 | 0.1 |
| C. Ex. 1 | 60 | 40 | 54.1 | 45.9 | 5.9 |
| (Simple mixture comA) | | | | | |
| C. Ex. 2 | 50 | 50 | 42.8 | 57.2 | 7.2 |
| (Simple mixture comB) | | | | | |
| C. Ex. 3 | 70 | 30 | 63.4 | 36.6 | 6.6 |
| (Simple mixture comC) | | | | | |

As shown in Table 3, it was confirmed that when the emission layer thin film of the green organic EL device was formed using pellets P1, P281, and P282 (Examples 1, 281 to 282) through a continuous process, the thin film was reproducibly and consistently formed, compared to when the emission layer thin film of the green organic EL device was formed using the simple mixtures of compounds A-1 and E-1 (Comparative Examples 1 to 3) through a continuous process.

## Claims

1. A pellet for an organic electroluminescent device, comprising two or more types of organic compound powders, including a first organic compound powder and a second organic compound powder that have been compressed, wherein the pellet has the same maximum emission wavelength as the organic compound with a longer emission wavelength among the first organic compound and the second organic compound.

2. The pellet of claim 1, wherein the pellet has the same maximum emission wavelength as the mixture of the first organic compound powder and the second organic compound powder.

3. The pellet of claim 1, wherein the pellet comprises:
a first region having a first organic compound powder compressed therein, and
a second region having second organic compound powder compressed therein and integrated with the first region.

4. The pellet of claim 1, wherein the first region and the second region are alternately arranged in a radial direction from the center outward.

5. The pellet of claim 3, wherein the first region and the second region are arranged in a longitudinal direction.

6. The pellet of claim 5, wherein the first region and the second region are arranged in an alternating pattern.

7. The pellet of claim 3, wherein the first region and the second region are alternately arranged in a circumferential direction.

8. The pellet of claim 7, wherein the first region and the second region are alternately arranged in an upper and lower configuration.

9. The pellet of claim 3, wherein the pellet has a shape selected from the group consisting of polyhedral, cylindrical, and spherical shapes.

10. The pellet of claim 1, wherein the first organic compound powder and the second organic compound powder are contained at a weight ratio of 1:99 to 99:1.

11. The pellet of claim 1, wherein both the first organic compound powder and the second organic compound powder are sublimable powders.

12. The pellet of claim 1, wherein
the first organic compound is a hole-transporting organic compound; and
the second organic compound is an electron-transporting organic compound.

13. The pellet of claim 12, wherein the hole-transporting organic compound is a hole-transporting host.

14. The pellet of claim 12, wherein the hole-transporting host is a carbazole-based compound.

15. The pellet of claim 12, wherein the electron-transporting organic compound is an electron-transporting host.

16. The pellet of claim 15, wherein the electron-transporting host is an azine-based compound.

17. The pellet of claim 1, wherein the two or more types of organic compound powders are injection molded into the pellet without heat treatment while a pressure of 20,000-40,000 kgf/cm² is applied thereto.

18. The pellet of claim 1, wherein the first organic compound powder and the second organic compound powder have a deposition temperature difference of 0 to 30°C under a pressure of 10⁻⁶ torr.

19. The pellet of claim 1, wherein the pellet has a BET specific surface area smaller than that of the simple mixture of the first and second organic compound powders.

20. The pellet of claim 1, wherein the pellet has a surface resistance smaller than that of the simple mixture of the first and second organic compound powders.

21. An organic electroluminescent device, comprising: an anode; a cathode; and at least one organic layer interposed between the anode and cathode, wherein at least one of the organic layers is a homogeneous thin film containing the first and second organic compounds formed using the pellet of any one of claims 1 to 20.
